# EUROPEAN PATENT APPLICATION

(11) **EP 3 121 000 A1**
(43) Date of publication of application: **25.01.2017**
(21) Application number: 15764950.0
(22) Date of filing: 18.03.2015
(51) Int. Cl.: B32B 9/00, B05D 7/24, B65D 65/40, C09D 1/00, F16L 59/065, H01L 31/048

(54) **MULTILAYER STRUCTURE AND METHOD FOR PRODUCING SAME, PACKAGING MATERIAL AND PRODUCT WHICH USE SAME, ELECTRONIC-DEVICE PROTECTIVE SHEET, AND COATING LIQUID**

(30) Priority: 18.03.2014 JP 2014054968; 13.08.2014 JP 2014164639; 13.08.2014 JP 2014164641; 13.08.2014 JP 2014164643
(71) Applicant: Kuraray Co., Ltd., Kurashiki-shi, Okayama 710-0801 (JP)
(72) Inventor: SASAKI, Ryoichi, Kurashiki-shi Okayama 713-8550 (JP); INUBUSHI, Yasutaka, Kurashiki-shi Okayama 713-8550 (JP); NAKAYA, Masakazu, Kurashiki-shi Okayama 713-8550 (JP); YOSHIDA, Kentaro, Kurashiki-shi Okayama 713-8550 (JP); OSHITA, Tatsuya, Kurashiki-shi Okayama 710-0801 (JP); TAKAI, Jun, Tsukuba-shi Ibaraki 305-0841 (JP); ARIMOTO, Kikuo, Tsukuba-shi Ibaraki 305-0841 (JP)
(74) Representative: Müller-Boré & Partner Patentanwälte PartG mbB
(86) International application number: PCT/JP2015/001528
(87) International publication number: WO 2015/141225

(57) **Abstract**

The present invention relates to a multilayer structure including a base (X) and a layer (Y) stacked on the base (X), the layer (Y) containing the following at a specific ratio: a metal oxide (A); a phosphorus compound (B) containing a moiety capable of reacting with the metal oxide (A); and cations (Z) with an ionic charge (Fz) of 1 or more and 3 or less.

## Description

### TECHNICAL FIELD

The present invention relates to a multilayer structure, a method for producing the multilayer structure, a packaging material and a product that include the multilayer structure, a protective sheet for electronic devices, and a coating liquid.

### BACKGROUND ART

Packaging materials for packaging various articles such as foods are often required to have barrier properties against gases such as oxygen. The use of a packaging material having poor gas barrier properties could, for example, cause oxidation by oxygen or food decay by proliferation of microorganisms, thus leading to deterioration of the contents. Conventional packaging materials therefore generally include a gas barrier layer for preventing penetration of oxygen or other gases.

A known example of such a gas barrier layer is a film containing a vinyl alcohol polymer (e.g., polyvinyl alcohol or ethylene-vinyl alcohol copolymer). Such a layer containing a vinyl alcohol polymer has the advantages of being transparent and less problematic in terms of disposal; however, it has the disadvantage of being inferior in water vapor barrier properties.

As a gas barrier layer having barrier properties against oxygen and water vapor there is known a film including a polymer film on which a metal oxide (such as silicon oxide, aluminum oxide, or magnesium oxide) is deposited. However, the deposited layer of metal oxide may be cracked due to deformation of or impact on the packaging material, with the result that the gas barrier properties significantly deteriorate. To solve this problem, Patent Literature 1 discloses a gas barrier film in which a protective layer made of an organic compound is formed on an inorganic deposited layer. In addition, Patent Literature 2 discloses a method for forming a coating film of a metal phosphate on a shaped product.

As for coating layers containing a phosphorus compound or silicon compound, Patent Literature 3 discloses a method for forming a coating layer using a solution of an aluminum salt and a phosphoric acid ester in an organic solvent. Patent Literature 4 discloses a method for forming a coating layer using a solution containing a silicon compound and an aluminum compound.

Patent Literature 5 describes a composite structure including a base (X) and a layer (Y) stacked on the base (X). In this composite structure, the layer (Y) includes a reaction product, and the reaction product is a reaction product formed by a reaction at least between a metal oxide and a phosphorus compound. In an infrared absorption spectrum of the layer (Y), the maximum absorption wavenumber in the region of 800 to 1,400 cm⁻¹ is 1,080 to 1,130 cm⁻¹.

Patent Literature 6 and Patent Literature 7 each disclose a multilayer structure that has good gas barrier properties and can maintain the gas barrier properties at a high level even when exposed to physical stresses such as deformation and impact.

### CITATION LIST

### Patent Literature

Patent Literature 1: JP 2006-175784 A
Patent Literature 2: JP 48-40869 A
Patent Literature 3: JP 2008-516015 A
Patent Literature 4: WO 2009/125800 A1
Patent Literature 5: WO 2011/122036 A1
Patent Literature 6: JP 2013-208793 A
Patent Literature 7: JP 2013-208794 A

### SUMMARY OF INVENTION

### Technical Problem

Nowadays, there is a demand for packaging materials that are superior in oxygen barrier properties and water vapor barrier properties and suffer less deterioration in barrier properties due to physical stresses such as deformation and impact. The conventional techniques as mentioned above may fail to fully meet such a demand. Additionally, in the case of the conventional techniques, the multilayer structure may lack sufficient gas barrier properties or water vapor barrier properties in practical use.

It is therefore an object of the present invention to provide a multilayer structure superior in both gas barrier properties and water vapor barrier properties and highly resistant to physical stresses. Another object of the present invention is to provide a method and a coating liquid for producing the multilayer structure. Still another object of the present invention is to provide a novel packaging material highly resistant to physical stresses and a product including the packaging material. Still another object of the present invention is to provide a protective sheet for electronic devices that is highly resistant to physical stresses and superior in gas barrier properties and water vapor barrier properties.

### Solution to Problem

As a result of a detailed study aimed at attaining the above objects, the present inventors have found that the use of a specified coating liquid allows the formation of a coating layer that is superior in both gas barrier properties and water vapor barrier properties and that maintains both of the barrier properties at high levels even after being exposed to physical stresses such as stretching. The present inventors have completed the present invention by conducting a further study based on the above new findings.

The present invention provides a multilayer structure including a base (X) and a layer (Y) stacked on the base (X), wherein the layer (Y) includes a metal oxide (A), a phosphorus compound (B), and cations (Z) with an ionic charge (Fz) of 1 or more and 3 or less, the phosphorus compound (B) includes a compound containing a moiety capable of reacting with the metal oxide (A), the number of moles (N_{M}) of metal atoms (M) constituting the metal oxide (A) and the number of moles (N_{P}) of phosphorus atoms derived from the phosphorus compound (B) satisfy a relationship of 0.8 ≤ N_{M}/N_{P} ≤ 4.5 in the layer (Y), and the number of moles (N_{M}), the number of moles (N_{Z}) of the cations (Z), and the ionic charge (F_{Z}) satisfy a relationship of 0.001 ≤ F_{Z} × N_{Z}/N_{M} ≤ 0.60 in the layer (Y).

The cations (Z) may include at least one selected from the group consisting of lithium ions, sodium ions, potassium ions, magnesium ions, calcium ions, titanium ions, zirconium ions, lanthanoid ions, vanadium ions, manganese ions, iron ions, cobalt ions, nickel ions, copper ions, zinc ions, boron ions, aluminum ions, and ammonium ions.

The number of moles (N_{M}), the number of moles (Nz), and the ionic charge (F_{Z}) may satisfy a relationship of 0.01 ≤ F_{Z} × N_{Z}/N_{M} ≤ 0.60 in the layer (Y).

The phosphorus compound (B) may include at least one compound selected from the group consisting of phosphoric acid, polyphosphoric acid, phosphorous acid, phosphonic acid, phosphonous acid, phosphinic acid, phosphinous acid, and derivatives thereof.

In an infrared absorption spectrum of the layer (Y), a maximum absorption wavenumber in a region of 800 to 1,400 cm⁻¹ may be 1,080 to 1,130 cm⁻¹.

The base (X) may include at least one layer selected from the group consisting of a thermoplastic resin film layer, a paper layer, and an inorganic deposited layer.

The present invention provides a method for producing a multilayer structure, the method including:
a step [I] of mixing a metal oxide (A), a phosphorus compound (B) containing a moiety capable of reacting with the metal oxide (A), and an ionic compound (E) containing cations (Z) with an ionic charge (Fz) of 1 or more and 3 or less, so as to prepare a first coating liquid (U);
a step [II] of applying the first coating liquid (U) onto the base (X) to form a precursor layer of the layer (Y) on the base (X); and
a step [III] of heat-treating the precursor layer at a temperature of 110°C or higher, wherein
the number of moles (N_{M}) of metal atoms (M) constituting the metal oxide (A) and the number of moles (N_{P}) of phosphorus atoms derived from the phosphorus compound (B) satisfy a relationship of 0.8 ≤ N_{M}/N_{P} ≤ 4.5 in the first coating liquid (U), and
the number of moles (N_{M}), the number of moles (N_{Z}) of the cations (Z), and the ionic charge (F_{Z}) satisfy a relationship of 0.001 ≤ F_{Z} × N_{Z}/N_{M} ≤ 0.60 in the first coating liquid (U).

The production method of the present invention may include a step [i] of preparing a second coating liquid (V) containing a polymer (G1) and a solvent; and a step [ii] of forming a layer (W) placed contiguous to the layer (Y) using the second coating liquid (V).

The present invention provides a coating liquid (first coating liquid (U)). This coating liquid includes a metal oxide (A), a phosphorus compound (B) containing a moiety capable of reacting with the metal oxide (A), and cations (Z) with an ionic charge (F_{Z}) of 1 or more and 3 or less, wherein the cations (Z) include at least one selected from the group consisting of lithium ions, sodium ions, potassium ions, magnesium ions, calcium ions, titanium ions, zirconium ions, lanthanoid ions, vanadium ions, manganese ions, iron ions, cobalt ions, nickel ions, copper ions, zinc ions, boron ions, aluminum ions, and ammonium ions, the number of moles (N_{M}) of metal atoms (M) constituting the metal oxide (A) and the number of moles (N_{P}) of phosphorus atoms derived from the phosphorus compound (B) satisfy a relationship of 0.8 ≤ Nm/Np ≤ 4.5, and the number of moles (N_{M}), the number of moles (N_{Z}) of the cations (Z), and the ionic charge (F_{Z}) satisfy a relationship of 0.001 ≤ F_{Z} × N_{Z}/N_{M} ≤ 0.60.

The present invention provides a packaging material including the multilayer structure.

The packaging material may further include a layer formed by extrusion coating lamination.

The packaging material of the present invention may be a vertical form-fill-seal bag, a vacuum packaging bag, a pouch, a laminated tube container, an infusion bag, a paper container, a strip tape, a container lid, or an in-mold labeled container.

The present invention provides a product including any of the above packaging materials in at least a part of the product.

The product of the present invention may be adapted to function as a vacuum insulator. That is, the product may have an interior with a reduced pressure and include a substance contained in the interior, the substance being a core material.

The present invention provides a protective sheet for electronic devices that includes the multilayer structure.

The protective sheet of the present invention may be a protective sheet adapted to protect a surface of a photoelectric conversion device, an information display device, or a lighting device.

The present invention provides an electronic device including the protective sheet.

### Advantageous Effects of Invention

By virtue of including the layer (Y) as defined above, the multilayer structure of the present invention is superior in both gas barrier properties and water vapor barrier properties and maintains both of the barrier properties at high levels even after being subjected to a stretching process. With the production method of the present invention, the multilayer structure can easily be produced. Additionally, the present invention makes it possible to obtain a novel packaging material highly resistant to physical stresses and a product including the packaging material. Furthermore, the present invention makes it possible to obtain a protective sheet for electronic devices that is highly resistant to physical stresses and is superior in gas barrier properties and water vapor barrier properties. The use of the protective sheet makes it possible to obtain an electronic device that suffers little deterioration even under harsh conditions. The term "gas barrier properties" as used herein refers to the ability to function as a barrier against gases other than water vapor, unless otherwise specified. The simpler term "barrier properties" as used herein collectively refers to both gas barrier properties and water vapor barrier properties.

### BRIEF DESCRIPTION OF DRAWINGS

FIG. 1 is a view showing the configuration of a vertical form-fill-seal bag according to an embodiment of the present invention.
FIG. 2 is a schematic cross-sectional view of a vacuum packaging bag according to an embodiment of the present invention.
FIG. 3 is a view showing the configuration of a flat pouch according to an embodiment of the present invention.
FIG. 4 is a view showing the configuration of a laminated tube container according to an embodiment of the present invention.
FIG. 5 is a view showing the configuration of an infusion bag according to an embodiment of the present invention.
FIG. 6 is a view showing the configuration of a paper container according to an embodiment of the present invention.
FIG. 7 is a view showing the configuration of an in-mold labeled container according to an embodiment of the present invention.
FIG. 8 is a schematic cross-sectional view of a vacuum insulator according to an embodiment of the present invention.
FIG. 9 is a schematic cross-sectional view of a vacuum insulator according to another embodiment of the present invention.
FIG. 10 is a partial cross-sectional view of an electronic device according to an embodiment of the present invention.
FIG. 11 is a perspective view schematically showing a part of an extrusion coating lamination apparatus used in the present invention.

### DESCRIPTION OF EMBODIMENTS

Hereinafter, the present invention will be described with reference to examples. The following description gives examples of materials, conditions, techniques, and value ranges; however, the present invention is not limited to those mentioned as examples. The materials given as examples may be used alone or may be used in combination with one another, unless otherwise specified.

Unless otherwise specified, the meaning of an expression like "a particular layer is stacked on a particular member (such as a base or layer)" as used herein encompasses not only the case where the particular layer is stacked in direct contact with the member but also the case where the particular layer is stacked above the member, with another layer interposed therebetween. The same applies to expressions like "a particular layer is formed on a particular member (such as a base or layer)" and "a particular layer is placed on a particular member (such as a base or layer)". Unless otherwise specified, the meaning of an expression like "a liquid (such as a coating liquid) is applied onto a particular member (such as a base or layer)" encompasses not only the case where the liquid is applied directly to the member but also the case where the liquid is applied to another layer formed on the member.

Herein, a layer may be termed "layer (Y)" using a reference character "(Y)" to differentiate the layer from other layers. The reference character "(Y)" has no technical meaning, unless otherwise specified. The same applies to other reference characters used in the terms such as "base (X)", "layer (W)", and "metal oxide (A)". However, an exception is made for the terms such as "hydrogen atom (H)" in which the reference character obviously represents a specific element.

### [Multilayer structure]

A multilayer structure of the present invention includes a base (X) and a layer (Y) stacked on the base (X). The layer (Y) includes a metal oxide (A), a phosphorus compound (B), and cations (Z) with an ionic charge (F_{Z}) of 1 or more and 3 or less. The phosphorus compound (B) contains a moiety capable of reacting with the metal oxide (A). In the layer (Y) of the multilayer structure of the present invention, the number of moles (N_{M}) of metal atoms (M) constituting the metal oxide (A) and the number of moles (N_{P}) of phosphorus atoms derived from the phosphorus compound (B) satisfy a relationship of 0.8 ≤ N_{M}/N_{P} ≤ 4.5. Furthermore, in the layer (Y), the number of moles (N_{M}) of the metal atoms (M) constituting the metal oxide (A), the number of moles (N_{Z}) of the cations (Z), and the ionic charge (F_{Z}) of the cations (Z) satisfy a relationship of 0.001 ≤ F_{Z} × N_{Z}/N_{M} ≤ 0.60. The metal atoms (M) refer to all metal atoms included in the metal oxide (A). The term "multilayer structure" as used in the following description refers to a multilayer structure that includes the base (X) and the layer (Y), unless otherwise specified.

The metal oxide (A) and the phosphorus compound (B) included in the layer (Y) may have undergone a reaction. The cations (Z) may have formed a salt with the phosphorus compound (B) in the layer (Y). When the metal oxide (A) has undergone a reaction in the layer (Y), a moiety derived from the metal oxide (A) in the reaction product is regarded as the metal oxide (A). When the phosphorus compound (B) has undergone a reaction in the layer (Y), the number of moles of phosphorus atoms in the reaction product which are derived from the phosphorus compound (B) is included in the number of moles (N_{P}) of phosphorus atoms derived from the phosphorus compound (B). When the cations (Z) have formed a salt in the layer (Y), the number of moles of the cations (Z) constituting the salt is included in the number of moles (N_{Z}) of the cations (Z).

The multilayer structure of the present invention exhibits good barrier properties by virtue of the relationship of 0.8 ≤ N_{M}/N_{P} ≤ 4.5 being satisfied in the layer (Y). Additionally, by virtue of the relationship of 0.001 ≤ F_{Z} × N_{Z}/N_{M} ≤ 0.60 being satisfied in the layer (Y), the multilayer structure of the present invention exhibits good barrier properties even after being exposed to physical stresses such as that caused by a stretching process.

The ratio (molar ratio) among N_{M}, N_{P}, and Nz in the layer (Y) can be considered equal to that employed in preparation of the first coating liquid (U).

### [Base (X)]

The material of the base (X) is not particularly limited, and a base made of any of various materials can be used. Examples of the material of the base (X) include: resins such as thermoplastic resins and thermosetting resins; fiber assemblies such as fabric and paper; wood; glass; metals; and metal oxides. Among these, thermoplastic resins and fiber assemblies are preferred, and thermoplastic resins are more preferred. The form of the base (X) is not particularly limited, and the base (X) may be in the form of a layer such as in the form of a film or sheet. It is preferable for the base (X) to include at least one selected from the group consisting of a thermoplastic resin film layer, a paper layer, and an inorganic deposited layer. In this case, the base may consist of a single layer or may include two or more layers. It is more preferable for the base (X) to include a thermoplastic resin film layer, and the base (X) may further include an inorganic deposited layer (X') in addition to the thermoplastic resin film layer.

Examples of the thermoplastic resin used in the base (X) include: polyolefin resins such as polyethylene and polypropylene; polyester resins such as polyethylene terephthalate, polyethylene-2,6-naphthalate, polybutylene terephthalate, and copolymers thereof polyamide resins such as nylon-6, nylon-66, and nylon-12; hydroxy group-containing polymers such as polyvinyl alcohol and ethylene-vinyl alcohol copolymer; polystyrene; poly(meth)acrylic acid ester; polyacrylonitrile; polyvinyl acetate; polycarbonate; polyarylate; regenerated cellulose; polyimide; polyetherimide; polysulfone; polyethersulfone; polyetheretherketone; and ionomer resins. When the multilayer structure is used in a packaging material, at least one thermoplastic resin selected from the group consisting of polyethylene, polypropylene, polyethylene terephthalate, nylon-6, and nylon-66 is preferred as the material of the base (X).

When a film made of such a thermoplastic resin is used as the base (X), the base (X) may be an oriented film or a non-oriented film. In terms of high suitability for processes (such as suitability for printing or lamination) of the resulting multilayer structure, an oriented film, particularly a biaxially-oriented film, is preferred. The biaxially-oriented film may be a biaxially-oriented film produced by any one method selected from simultaneous biaxial stretching, sequential biaxial stretching, and tubular stretching.

Examples of the paper used in the base (X) include kraft paper, high-quality paper, simili paper, glassine paper, parchment paper, synthetic paper, white paperboard, manila board, milk carton board, cup paper, and ivory paper. The use of paper in the base (X) makes it possible to obtain a multilayer structure for a paper container.

### [Inorganic deposited layer (X')]

The inorganic deposited layer (X') is preferably one that has barrier properties against oxygen and water vapor and more preferably one that further has transparency. The inorganic deposited layer (X') can be obtained by vapor deposition of an inorganic substance. Examples of the inorganic substance include metals (such as aluminum), metal oxides (such as silicon oxide and aluminum oxide), metal nitrides (such as silicon nitride), metal oxynitrides (such as silicon oxynitride), and metal carbonitrides (such as silicon carbonitride). Among these, aluminum oxide, silicon oxide, magnesium oxide, and silicon nitride are preferred in that an inorganic deposited layer formed of any of these substances has good barrier properties against oxygen and water vapor.

The method for forming the inorganic deposited layer (X') is not particularly limited, and available methods include: physical vapor deposition processes such as vacuum vapor deposition (e.g., resistive heating vapor deposition, electron beam vapor deposition, and molecular beam epitaxy), sputtering, and ion plating; and chemical vapor deposition processes such as thermal chemical vapor deposition (e.g., catalytic chemical vapor deposition), photochemical vapor deposition, plasma chemical vapor deposition (e.g., capacitively coupled plasma process, inductively coupled plasma process, surface wave plasma process, electron cyclotron resonance plasma process, and dual magnetron process), atomic layer deposition, and organometallic vapor deposition.

The thickness of the inorganic deposited layer (X') is preferably in the range of 0.002 to 0.5 µm, more preferably in the range of 0.005 to 0.2 µm, and even more preferably in the range of 0.01 to 0.1 µm, although the preferred thickness may vary depending on the type of the component constituting the inorganic deposited layer (X'). A thickness at which good barrier properties and mechanical properties of the multilayer structure are achieved can be selected within the above range. If the thickness of the inorganic deposited layer (X') is less than 0.002 µm, the repeatability of exhibition of the barrier properties of the inorganic deposited layer against oxygen and water vapor is likely to diminish, and the inorganic deposited layer may fail to exhibit sufficient barrier properties. If the thickness of the inorganic deposited layer (X') is more than 0.5 µm, the barrier properties of the inorganic deposited layer (X') are likely to deteriorate when the multilayer structure is pulled or bent.

The method for forming the inorganic deposited layer (X') is not particularly limited. For example, the following methods can be used: physical vapor deposition processes such as vacuum vapor deposition (e.g., resistive heating vapor deposition, electron beam vapor deposition, and molecular beam epitaxy), sputtering, and ion plating; and chemical vapor deposition processes such as thermal chemical vapor deposition (e.g., catalytic chemical vapor deposition), photochemical vapor deposition, plasma chemical vapor deposition (e.g., capacitively coupled plasma process, inductively coupled plasma process, surface wave plasma process, electron cyclotron resonance plasma process, and dual magnetron process), atomic layer deposition, and organometallic vapor deposition. The inorganic deposited layer (X') may be vapor-deposited on the layer (Y).

When the base (X) is in the form of a layer, the thickness of the base (X) is preferably in the range of 1 to 1,000 µm, more preferably in the range of 5 to 500 µm, and even more preferably in the range of 9 to 200 µm, in terms of high mechanical strength and good processability of the resulting multilayer structure.

### [Layer (Y)]

The layer (Y) includes the metal oxide (A), the phosphorus compound (B), and the cations (Z) with an ionic charge of 1 or more and 3 or less. Each of the components will now be described.

### [Metal oxide (A)]

It is preferable for the metal atoms (M) constituting the metal oxide (A) to have two or more valences. Examples of the metal atoms (M) include: atoms of Group 2 metals of the periodic table such as magnesium and calcium; atoms of Group 4 metals of the periodic table such as titanium and zirconium; atoms of Group 12 metals of the periodic table such as zinc; atoms of Group 13 metals of the periodic table such as boron and aluminum; and atoms of Group 14 metals of the periodic table such as silicon. As the case may be, boron and silicon are classified as semimetal elements. However, these elements are categorized as metal elements herein. The metal atoms (M) may consist of one type of atoms or may include two or more types of atoms. Among the above examples, atoms of at least one selected from the group consisting of aluminum, titanium, and zirconium are preferred as the metal atoms (M), and more preferred are aluminum atoms, in terms of efficiency of production of the metal oxide (A) and better gas barrier properties and water vapor barrier properties of the resulting multilayer structure. That is, it is preferable for the metal atoms (M) to include aluminum atoms.

The total proportion of aluminum, titanium, and zirconium atoms in the metal atoms (M) is typically 60 mol% or more and may be 100 mol%. The proportion of aluminum atoms in the metal atoms (M) is typically 50 mol% or more and may be 100 mol%. The metal oxide (A) can be produced by methods such as liquid-phase synthesis, gas-phase synthesis, and solid grinding.

The metal oxide (A) may be a hydrolytic condensate of a compound (L) having the metal atom (M) to which a hydrolyzable characteristic group is bonded. Examples of the characteristic group include those represented by R¹ in the general formula [I] given below. The hydrolytic condensate of the compound (L) can be substantially regarded as the metal oxide (A). Hence, the term "metal oxide (A)" as used herein is interchangeable with the term "hydrolytic condensate of the compound (L)", while the term "hydrolytic condensate of the compound (L)" as used herein is interchangeable with the term "metal oxide (A)".

[Compound (L) containing metal atom (M) to which hydrolyzable characteristic group is bonded]

In terms of ease of control of the reaction with the phosphorus compound (B) and in terms of good gas barrier properties of the resulting multilayer structure, it is preferable for the compound (L) to include at least one compound (L¹) represented by the following general formula [I].

M¹(R¹)ₘ(R²)ₙ₋ₘ [I]

In the formula, M¹ is selected from the group consisting of aluminum, titanium, and zirconium. R¹ is a halogen atom (fluorine atom, chlorine atom, bromine atom, or iodine atom), NO₃, an optionally substituted alkoxy group having 1 to 9 carbon atoms, an optionally substituted acyloxy group having 1 to 9 carbon atoms, an optionally substituted alkenyloxy group having 3 to 9 carbon atoms, an optionally substituted β-diketonato group having 5 to 15 carbon atoms, or a diacylmethyl group having an optionally substituted acyl group having 1 to 9 carbon atoms. R² is an optionally substituted alkyl group having 1 to 9 carbon atoms, an optionally substituted aralkyl group having 7 to 10 carbon atoms, an optionally substituted alkenyl group having 2 to 9 carbon atoms, or an optionally substituted aryl group having 6 to 10 carbon atoms. m is an integer of 1 to n. n is equal to the valence of M¹. When there are two or more atoms or groups represented by R¹, the atoms or groups represented by R¹ may be the same as or different from each other. When there are two or more groups represented by R², the atoms or groups represented by R² may be the same as or different from each other.

Examples of the alkoxy group represented by R¹ include methoxy, ethoxy, n-propoxy, isopropoxy, n-butoxy, isobutoxy, sec-butoxy, tert-butoxy, benzyloxy, diphenylmethoxy, trityloxy, 4-methoxybenzyloxy, methoxymethoxy, 1-ethoxyethoxy, benzyloxymethoxy, 2-trimethylsilylethoxy, 2-trimethylsilylethoxymethoxy, phenoxy, and 4-methoxyphenoxy groups.

Examples of the acyloxy group represented by R¹ include acetoxy, ethylcarbonyloxy, n-propylcarbonyloxy, isopropylcarbonyloxy, n-butylcarbonyloxy, isobutylcarbonyloxy, sec-butylcarbonyloxy, tert-butylcarbonyloxy, and n-octylcarbonyloxy groups.

Examples of the alkenyloxy group represented by R¹ include allyloxy, 2-propenyloxy, 2-butenyloxy, 1-methyl-2-propenyloxy, 3-butenyloxy, 2-methyl-2-propenyloxy, 2-pentenyloxy, 3-pentenyloxy, 4-pentenyloxy, 1-methyl-3-butenyloxy, 1,2-dimethyl-2-propenyloxy, 1,1-dimethyl-2-propenyloxy, 2-methyl-2-butenyloxy, 3-methyl-2-butenyloxy, 2-methyl-3-butenyloxy, 3-methyl-3-butenyloxy, 1-vinyl-2-propenyloxy, and 5-hexenyloxy groups.

Examples of the β-diketonato group represented by R¹ include 2,4-pentanedionato, 1,1,1-trifluoro-2,4-pentanedionato, 1,1,1,5,5,5-hexafluoro-2,4-pentanedionato, 2,2,6,6-tetramethyl-3,5-heptanedionato, 1,3-butanedionato, 2-methyl-1,3-butanedionato, 2-methyl-1,3-butanedionato, and benzoylacetonato groups.

Examples of the acyl group of the diacylmethyl group represented by R¹ include: aliphatic acyl groups having 1 to 6 carbon atoms such as formyl, acetyl, propionyl (propanoyl), butyryl (butanoyl), valeryl (pentanoyl), and hexanoyl groups; and aromatic acyl (aroyl) groups such as benzoyl and toluoyl groups.

Examples of the alkyl group represented by R² include methyl, ethyl, n-propyl, isopropyl, n-butyl, isobutyl, sec-butyl, tert-butyl, n-pentyl, isopentyl, n-hexyl, isohexyl, 3-methylpentyl, 2-methylpentyl, 1,2-dimethylbutyl, cyclopropyl, cyclopentyl, and cyclohexyl groups.

Examples of the aralkyl group represented by R² include benzyl and phenylethyl (phenethyl) groups.

Examples of the alkenyl group represented by R² include vinyl, 1-propenyl, 2-propenyl, isopropenyl, 3-butenyl, 2-butenyl, 1-butenyl, 1-methyl-2-propenyl, 1-methyl-1-propenyl, 1-ethyM-ethenyl, 2-methyl-2-propenyl, 2-methyl-1-propenyl, 3-methyl-2-butenyl, and 4-pentenyl groups.

Examples of the aryl group represented by R² include phenyl, 1-naphthyl, and 2-naphthyl groups.

Examples of the substituents in R¹ and R² include: alkyl groups having 1 to 6 carbon atoms; alkoxy groups having 1 to 6 carbon atoms such as methoxy, ethoxy, n-propoxy, isopropoxy, n-butoxy, isobutoxy, sec-butoxy, tert-butoxy, n-pentyloxy, isopentyloxy, n-hexyloxy, cyclopropyloxy, cyclobutyloxy, cyclopentyloxy, and cyclohexyloxy groups; alkoxycarbonyl groups having 1 to 6 carbon atoms such as methoxycarbonyl, ethoxycarbonyl, n-propoxycarbonyl, isopropoxycarbonyl, n-butoxycarbonyl, isobutoxycarbonyl, sec-butoxycarbonyl, tert-butoxycarbonyl, n-pentyloxycarbonyl, isopentyloxycarbonyl, cyclopropyloxycarbonyl, cyclobutyloxycarbonyl, and cyclopentyloxycarbonyl groups; aromatic hydrocarbon groups such as phenyl, tolyl, and naphthyl groups; halogen atoms such as fluorine, chlorine, bromine, and iodine atoms; acyl groups having 1 to 6 carbon atoms; aralkyl groups having 7 to 10 carbon atoms; aralkyloxy groups having 7 to 10 carbon atoms; alkylamino groups having 1 to 6 carbon atoms; and dialkylamino groups having an alkyl group having 1 to 6 carbon atoms.

It is preferable for R¹ to be a halogen atom, NO₃, an optionally substituted alkoxy group having 1 to 6 carbon atoms, an optionally substituted acyloxy group having 1 to 6 carbon atoms, an optionally substituted β-diketonato group having 5 to 10 carbon atoms, or a diacylmethyl group having an optionally substituted acyl group having 1 to 6 carbon atoms.

It is preferable for R² to be an optionally substituted alkyl group having 1 to 6 carbon atoms. It is preferable for M¹ to be aluminum. When M¹ is aluminum, m is preferably 3.

Specific examples of the compound (L¹) include: aluminum compounds such as aluminum nitrate, aluminum acetate, tris(2,4-pentanedionato)aluminum, trimethoxyaluminum, triethoxyaluminum, tri-n-propoxyaluminum, triisopropoxyaluminum, tri-n-butoxyaluminum, tri-sec-butoxyaluminum, and tri-tert-butoxyaluminum; titanium compounds such as tetrakis(2,4-pentanedionato)titanium, tetramethoxytitanium, tetraethoxytitanium, tetraisopropoxytitanium, tetra-n-butoxytitanium, and tetrakis(2-ethylhexoxy)titanium; and zirconium compounds such as tetrakis(2,4-pentanedionato)zirconium, tetra-n-propoxyzirconium, and tetra-n-butoxyzirconium. Among these, at least one compound selected from triisopropoxyaluminum and tri-sec-butoxyaluminum is preferred as the compound (L¹). One compound (L) may be used alone or two or more compounds (L) may be used in combination.

The proportion of the compound (L¹) in the compound (L) is not particularly limited as long as the effect of the present invention is obtained. The proportion of a compound other than the compound (L¹) in the compound (L) is preferably 20 mol% or less, more preferably 10 mol% or less, and even more preferably 5 mol% or less and may be 0 mol%, for example.

The compound (L) is hydrolyzed, so that at least some of the hydrolyzable characteristic groups possessed by the compound (L) are converted to hydroxy groups. The hydrolysate is then condensed to form a compound in which the metal atoms (M) are linked together via an oxygen atom (O). The repetitions of this condensation results in the formation of a compound that can be substantially regarded as a metal oxide. In general, the thus formed metal oxide (A) has hydroxy groups present on its surface.

A compound is categorized as the metal oxide (A) herein when the ratio, [the number of moles of the oxygen atoms (O) bonded only to the metal atoms (M)]/[the number of moles of the metal atoms (M)], is 0.8 or more in the compound. The "oxygen atom (O) bonded only to the metal atom (M)", as defined herein, refers to the oxygen atom (O) in the structure represented by M-O-M, and does not include an oxygen atom that is bonded to both the metal atom (M) and hydrogen atom (H) as is the case for the oxygen atom (O) in the structure represented by M-O-H. The above ratio in the metal oxide (A) is preferably 0.9 or more, more preferably 1.0 or more, and even more preferably 1.1 or more. The upper limit of this ratio is not particularly defined. When the valence of the metal atom (M) is denoted by n, the upper limit is typically represented by n/2.

In order for the hydrolytic condensation to take place, it is important that the compound (L) has hydrolyzable characteristic groups. When there are no such groups bonded, hydrolytic condensation reaction does not occur or proceeds very slowly, which makes difficult the preparation of the metal oxide (A) intended.

The hydrolytic condensate of the compound (L) may be produced, for example, from a particular raw material by a technique employed in commonly-known sol-gel processes. As the raw material there can be used at least one selected from the group consisting of the compound (L), a partial hydrolysate of the compound (L), a complete hydrolysate of the compound (L), a partial hydrolytic condensate of the compound (L), and a condensate formed by condensation of a part of a complete hydrolysate of the compound (L).

### [Phosphorus compound (B)]

The phosphorus compound (B) contains a moiety capable of reacting with the metal oxide (A) and typically contains two or more such moieties. It is preferable for the phosphorus compound (B) to be an inorganic phosphorus compound. It is preferable for the phosphorus compound (B) to be a compound containing 2 to 20 moieties (atomic groups or functional groups) capable of reacting with the metal oxide (A). These moieties include a moiety capable of undergoing a condensation reaction with a functional group (e.g., hydroxy group) present on the surface of the metal oxide (A). Examples of such a moiety include a halogen atom bonded directly to a phosphorus atom and an oxygen atom bonded directly to a phosphorus atom. In general, the functional group (e.g., hydroxy group) present on the surface of the metal oxide (A) is bonded to the metal atom (M) of the metal oxide (A).

Examples of the phosphorus compound (B) include: oxoacids of phosphorus such as phosphoric acid, polyphosphoric acid formed by condensation of 4 or more molecules of phosphoric acid, phosphorous acid, phosphonic acid, phosphonous acid, phosphinic acid, and phosphinous acid; salts thereof (e.g., sodium phosphate); and derivatives thereof (e.g., halides such as phosphoryl chloride and dehydrates such as phosphorus pentoxide).

One phosphorus compound (B) may be used alone or two or more phosphorus compounds (B) may be used in combination. Among the above examples of the phosphorus compound (B), phosphoric acid alone or a combination of phosphoric acid with another phosphorus compound (B) is preferably used. The use of phosphoric acid improves the stability of the first coating liquid (U) described later and the gas barrier properties and water vapor barrier properties of the resulting multilayer structure.

### [Ratio between metal oxide (A) and phosphorus compound (B)]

The multilayer structure of the present invention is one in which N_{M} and N_{P} in the layer (Y) are such as to satisfy a relationship of 0.8 ≤ N_{M}/N_{P} ≤ 4.5, preferably a relationship of 1.0 ≤ N_{M}/N_{P} ≤ 3.6, and more preferably a relationship of 1.1 ≤ N_{M}/N_{P} 3.0. If the value of N_{M}/N_{P} is more than 4.5, this means that the metal oxide (A) is excessive relative to the phosphorus compound (B). In this case, the bonding between the metal oxide (A) and the phosphorus compound (B) is insufficient, and the amount of hydroxy groups present on the surface of the metal oxide (A) is large, so that the gas barrier properties and the stability thereof tend to deteriorate. If the value of N_{M}/N_{P} is less than 0.8, this means that the phosphorus compound (B) is excessive relative to the metal oxide (A). In this case, the amount of the excess phosphorus compound (B) that is not involved in the bonding to the metal oxide (A) is large, and the amount of hydroxy groups derived from the phosphorus compound (B) is likely to be large, so that the barrier properties and the stability thereof tend to deteriorate.

The above ratio can be controlled depending on the ratio between the amount of the metal oxide (A) and the amount of the phosphorus compound (B) in the first coating liquid (U) for forming the layer (Y). The ratio between N_{M} and N_{P} in the layer (Y) typically corresponds to that in the first coating liquid (U) and is equal to the ratio between the number of moles of the metal atoms (M) constituting the metal oxide (A) and the number of moles of phosphorus atoms constituting the phosphorus compound (B).

### [Reaction product (D)]

A reaction product (D) is formed by a reaction between the metal oxide (A) and the phosphorus compound (B). It should be noted that a compound formed by a reaction among the metal oxide (A), the phosphorus compound (B), and another compound is also categorized as the reaction product (D). The reaction product (D) may partially include the metal oxide (A) and/or phosphorus compound (B) that has not been involved in the reaction.

### [Cations (Z)]

The ionic charge (Fz) of the cations (Z) is 1 or more and 3 or less. In the case where not only resistance to physical stresses but also resistance to hot water or hot steam are required, such as when retorting is performed, the ionic charge (Fz) is preferably 2 or more and 3 or less and more preferably 3. The cations (Z) are cations containing an element in any of the second to seventh periods of the periodic table. Examples of the cations (Z) include lithium ions, sodium ions, potassium ions, magnesium ions, calcium ions, titanium ions, zirconium ions, lanthanoid ions (e.g., lanthanum ions), vanadium ions, manganese ions, iron ions, cobalt ions, nickel ions, copper ions, zinc ions, boron ions, aluminum ions, and ammonium ions, among which magnesium ions, calcium ions, lanthanoid ions (e.g., lanthanum ions), zinc ions, and boron ions are preferred. The cations (Z) may consist of one type of cations or may include two or more types of cations. The action of the cations (Z) has not yet been clarified. A possible hypothesis is that the cations (Z) each form an ionic bond with a hydroxy group of one molecule of the metal oxide (A) or phosphorus compound (B) via a hydroxy group of another molecule of the metal oxide (A) or phosphorus compound (B) and thereby increase the resistance of the layer (Y) to physical stresses. That is why it may be preferable to use cations with a larger ionic charge (F_{Z}) which are capable of forming more ionic bonds when higher resistance is required.

When the cations (Z) include two or more types of cations having different ionic charges, the value of F_{Z} × N_{Z} is determined by summing up values calculated respectively for the different cations. When, for example, the cations (Z) include 1 mole of sodium ions (Na⁺) and 2 moles of calcium ions (Ca²⁺), the value of F_{Z} × N_{Z} is calculated as follows: F_{Z} × N_{Z} = 1 × 1 + 2 × 2 = 5.

The cations (Z) can be added to the layer (Y) by dissolving in the first coating liquid (U) an ionic compound (E) which releases the cations (Z) when dissolved in a solvent. Examples of counterions for the cations (Z) include: inorganic anions such as hydroxide ions, chloride ions, sulfate ions, hydrogen sulfate ions, nitrate ions, carbonate ions, and hydrogen carbonate ions; and organic acid anions such as acetate ions, stearate ions, oxalate ions, and tartrate ions. The ionic compound (E) for adding the cations (Z) may be a metal compound (Ea) or metal oxide (Eb) (different from the metal oxide (A)) which releases the cations (Z) when dissolved.

### [Ratio between metal oxide (A) and cations (Z)]

The multilayer structure of the present invention is one in which F_{Z}, N_{Z}, and N_{M} in the layer (Y) are such as to satisfy a relationship of 0.001 ≤ F_{Z} × N_{Z}/N_{M} ≤ 0.60, preferably a relationship of 0.001 ≤ F_{Z} × N_{Z}/N_{M} ≤ 0.30, and more preferably a relationship of 0.01 ≤ F_{Z} × N_{Z}/N_{M} ≤ 0.30.

### [Ratio between phosphorus compound (B) and cations (Z)]

The multilayer structure of the present invention is one in which F_{Z}, N_{Z}, and N_{P} in the layer (Y) are preferably such as to satisfy a relationship of 0.0008 ≤ F_{Z} × N_{Z}/N_{P} ≤ 1.35, more preferably a relationship of 0.001 ≤ F_{Z} × N_{Z}/N_{P} ≤ 1.00, even more preferably a relationship of 0.0012 ≤ F_{Z} × N_{Z}/N_{P} ≤ 0.35, and particularly preferably a relationship of 0.012 ≤ F_{Z} × N_{Z}/N_{P} ≤ 0.29 in the layer (Y).

### [Polymer (C)]

The layer (Y) may further include a particular polymer (C). The polymer (C) is, for example, a polymer containing at least one functional group selected from the group consisting of a carbonyl group, a hydroxy group, a carboxyl group, a carboxylic anhydride group, and a salt of a carboxyl group.

Examples of the polymer (C) include: polyketones; polyvinyl alcohol polymers such as polyvinyl alcohol, modified polyvinyl alcohol containing 1 to 50 mol% of α-olefin units having 4 or less carbon atoms, and polyvinyl acetal (e.g., polyvinyl butyral); polysaccharides such as cellulose, starch, and cyclodextrin; (meth)acrylic acid polymers such as polyhydroxyethyl (meth)acrylate, poly(meth)acrylic acid, and ethylene-acrylic acid copolymer; and maleic acid polymers such as a hydrolysate of ethylene-maleic anhydride copolymer, a hydrolysate of styrene-maleic anhydride copolymer, and a hydrolysate of isobutylene-maleic anhydride alternating copolymer. Among these, the polyvinyl alcohol polymers are preferred. More specifically, polyvinyl alcohol and modified polyvinyl alcohol containing 1 to 15 mol% of α-olefin units having 4 or less carbon atoms are preferred.

The degree of saponification of the polyvinyl alcohol polymer is preferably, but not limited to, 75.0 to 99.85 mol%, more preferably 80.0 to 99.5 mol%. The viscosity-average degree of polymerization of the polyvinyl alcohol polymer is preferably 100 to 4,000 and more preferably 300 to 3,000. The viscosity of a 4 mass% aqueous solution of the polyvinyl alcohol polymer at 20°C is preferably 1.0 to 200 mPa•s and more preferably 11 to 90 mPa•s. The values of the degree of saponification, the viscosity-average degree of polymerization, and the viscosity of the 4 mass% aqueous solution are those determined according to JIS K 6726 (1994).

The polymer (C) may be a homopolymer of a monomer having a polymerizable group (e.g., vinyl acetate or acrylic acid), may be a copolymer of two or more monomers, or may be a copolymer of a monomer having a carbonyl group, a hydroxy group, and/or a carboxyl group and a monomer having none of these groups.

The molecular weight of the polymer (C) is not particularly limited. In order to obtain a multilayer structure that has better barrier properties and mechanical properties (e.g., drop impact resistance), the number average molecular weight of the polymer (C) is preferably 5,000 or more, more preferably 8,000 or more, and even more preferably 10,000 or more. The upper limit of the number average molecular weight of the polymer (C) is not particularly defined and is, for example, 1,500,000 or less.

In order to further improve the barrier properties, the content of the polymer (C) in the layer (Y) is preferably 50 mass% or less, more preferably 40 mass% or less, even more preferably 30 mass% or less, and may be 20 mass%, with respect to the mass of the layer (Y) (defined as 100 mass%). The polymer (C) may or may not react with another component in the layer (Y).

### [Additional component in layer (Y)]

The layer (Y) of the multilayer structure may include an additional component other than the metal oxide (A), the compound (L), the phosphorus compound (B), the reaction product (D), the cations (Z) or the compound (E), an acid (such as an acid catalyst used for hydrolytic condensation or an acid for deflocculation), and the polymer (C). Examples of the additional component include: metal salts of inorganic acids such as a metal carbonate, a metal hydrochloride, a metal nitrate, a metal hydrogen carbonate, a metal sulfate, a metal hydrogen sulfate, and a metal borate that do not contain the cations (Z); metal salts of organic acids such as a metal acetate, a metal stearate, a metal oxalate, and a metal tartrate that do not contain the cations (Z); layered clay compounds; crosslinking agents; polymer compounds other than the polymer (C); plasticizers; antioxidants; ultraviolet absorbers; and flame retardants. The content of the additional component in the layer (Y) of the multilayer structure is preferably 50 mass% or less, more preferably 20 mass% or less, even more preferably 10 mass% or less, and particularly preferably 5 mass% or less and may be 0 mass% (which means that the additional component is not contained), with respect to the mass of the layer (Y).

### [Thickness of layer (Y)]

The thickness of the layer (Y) (or, for a multilayer structure having two or more layers (Y), the total thickness of the layers (Y)) is preferably 0.05 to 4.0 µm and more preferably 0.1 to 2.0 µm. Thinning the layer (Y) can provide a reduction in the dimensional change of the multilayer structure which may occur during a process such as printing or lamination. Thinning the layer (Y) can also provide an increase in the flexibility of the multilayer structure, thus making it possible to allow the multilayer structure to have mechanical characteristics close to the mechanical characteristics intrinsic to the base. When the multilayer structure of the present invention includes two or more layers (Y), it is preferable for the thickness of each layer (Y) to be 0.05 µm or more in terms of the gas barrier properties. The thickness of the layer (Y) can be controlled depending on the concentration of the later-described first coating liquid (U) used for forming the layer (Y) or the method for applying the liquid (U).

### [Infrared absorption spectrum of layer (Y)]

In an infrared absorption spectrum of the layer (Y), the maximum absorption wavenumber in the region of 800 to 1,400 cm⁻¹ is preferably 1,080 to 1,130 cm⁻¹. In the process in which the metal oxide (A) and the phosphorus compound (B) react to produce the reaction product (D), there is formed a bond, represented by M-O-P, in which the metal atom (M) derived from the metal oxide (A) and the phosphorus atom (P) derived from the phosphorus compound (B) are bonded via the oxygen atom (O). As a result, a characteristic absorption band attributed to the bond appears in the infrared absorption spectrum. A study by the present inventors has revealed that the resulting multilayer structure exhibits good gas barrier properties when the absorption band attributed to the bond M-O-P is observed in the region of 1,080 to 1,130 cm⁻¹. More specifically, it has been found that the resulting multilayer structure exhibits much better gas barrier properties when the characteristic absorption band corresponds to the strongest absorption in the region of 800 to 1,400 cm⁻¹ where absorptions attributed to bonds between various atoms and oxygen atoms are generally observed.

By contrast, if a metal compound such as a metal alkoxide or metal salt and the phosphorus compound (B) are first mixed together and the mixture is then subjected to hydrolytic condensation, the resultant is a composite material in which the metal atoms derived from the metal compound and the phosphorus atoms derived from the phosphorus compound (B) have been almost homogeneously mixed and reacted. In this case, in an infrared absorption spectrum of the composite material, the maximum absorption wavenumber in the region of 800 to 1,400 cm⁻¹ falls outside the range of 1,080 to 1,130 cm⁻¹.

In the infrared absorption spectrum of the layer (Y), the half width of the maximum absorption band in the region of 800 to 1,400 cm⁻¹ is preferably 200 cm⁻¹ or less, more preferably 150 cm⁻¹ or less, even more preferably 100 cm⁻¹ or less, and particularly preferably 50 cm⁻¹ or less, in terms of the gas barrier properties of the resulting multilayer structure.

The infrared absorption spectrum of the layer (Y) can be measured by the method described in "EXAMPLES" below. If the measurement is not possible by the method described in "EXAMPLES", the measurement may be conducted by another method, examples of which include, but are not limited to: reflection spectroscopy such as reflection absorption spectroscopy, external reflection spectroscopy, or attenuated total reflection spectroscopy; and transmission spectroscopy such as Nujol method or pellet method performed on the layer (Y) scraped from the multilayer structure.

### [Layer (W)]

The multilayer structure of the present invention may further include a layer (W). The layer (W) includes a polymer (G1) having a functional group containing a phosphorus atom. It is preferable for the layer (W) to be placed contiguous to the layer (Y). That is, it is preferable that the layer (W) and the layer (Y) be arranged in contact with each other. It is also preferable for the layer (W) to be placed opposite to the base (X) across the layer (Y) (preferably on one surface of the layer (Y) opposite to that facing the base (X)). In other words, it is preferable that the layer (Y) be placed between the base (X) and the layer (W). In a preferred example, the layer (W) is placed contiguous to the layer (Y) and opposite to the base (X) across the layer (Y) (preferably on one surface of the layer (Y) opposite to that facing the base (X)). The layer (W) may further include a polymer (G2) having a hydroxy group and/or a carboxyl group. The same polymer as the polymer (C) may be used as the polymer (G2). The polymer (G1) will now be described.

### [Polymer (G1)]

Examples of the phosphorus atom-containing functional group of the polymer (G1) include a phosphoric acid group, a phosphorous acid group, a phosphonic acid group, a phosphonous acid group, a phosphinic acid group, a phosphinous acid group, salts of these groups, and functional groups derived from these groups (e.g., (partially) esterified groups, halogenated groups such as chlorinated groups, and dehydrated groups). Among these, a phosphoric acid group and/or a phosphonic acid group is preferred, and a phosphonic acid group is more preferred.

Examples of the polymer (G1) include: polymers of phosphono(meth)acrylic acid esters such as 6-[(2-phosphonoacetyl)oxy]hexyl acrylate, 2-phosphonooxyethyl methacrylate, phosphonomethyl methacrylate, 11-phosphonoundecyl methacrylate, and 1,1-diphosphonoethyl methacrylate; polymers of phosphonic acids such as vinylphosphonic acid, 2-propene-1-phosphonic acid, 4-vinylbenzylphosphonic acid, and 4-vinylphenylphosphonic acid; polymers of phosphinic acids such as vinylphosphinic acid and 4-vinylbenzylphosphinic acid; and phosphorylated starch. The polymer (G1) may be a homopolymer of a monomer having at least one of the phosphorus atom-containing functional groups or may be a copolymer of two or more such monomers. Alternatively, a mixture of two or more polymers each consisting of a single monomer may be used as the polymer (G1). In particular, a polymer of a phosphono(meth)acrylic acid ester and/or a polymer of a vinylphosphonic acid is preferred, and a polymer of a vinylphosphonic acid is more preferred. The polymer (G1) is preferably poly(vinylphosphonic acid) or poly(2-phosphonooxyethyl methacrylate) and may be poly(vinylphosphonic acid). The polymer (G1) can be obtained also by homopolymerization or copolymerization of a vinylphosphonic acid derivative such as vinylphosphonic acid halide or vinylphosphonic acid ester, followed by hydrolysis.

Alternatively, the polymer (G1) may be a copolymer of a monomer having at least one phosphorus atom-containing functional group and a vinyl monomer. Examples of the vinyl monomer copolymerizable with the monomer having a phosphorus atom-containing functional group include (meth)acrylic acid, (meth)acrylic acid esters, acrylonitrile, methacrylonitrile, styrene, nuclear-substituted styrenes, alkyl vinyl ethers, alkyl vinyl esters, perfluoroalkyl vinyl ethers, perfluoroalkyl vinyl esters, maleic acid, maleic anhydride, fumaric acid, itaconic acid, maleimide, and phenylmaleimide. Among these, (meth)acrylic acid esters, acrylonitrile, styrene, maleimide, and phenylmaleimide are preferred.

In order to obtain a multilayer structure that has better bending resistance, the proportion of the structural units derived from the monomer having a phosphorus atom-containing functional group in the total structural units of the polymer (G1) is preferably 10 mol% or more, more preferably 20 mol% or more, even more preferably 40 mol% or more, and particularly preferably 70 mol% or more, and may be 100 mol%.

The molecular weight of the polymer (G1) is not particularly limited. It is preferable that the number average molecular weight be in the range of 1,000 to 100,000. When the number average molecular weight is in this range, both a high level of improving effect of stacking of the layer (W) on bending resistance and a high level of viscosity stability of the second coating liquid (V) described later can be achieved. When the layer (Y) described is stacked, the improving effect on bending resistance is further enhanced by using the polymer (G1) whose molecular weight per phosphorus atom is in the range of 100 to 500.

The layer (W) may consist only of the polymer (G1), may consist only of the polymer (G1) and the polymer (G2), or may further include an additional component. Examples of the additional component which may be included in the layer (W) include: metal salts of inorganic acids such as a metal carbonate, a metal hydrochloride, a metal nitrate, a metal hydrogen carbonate, a metal sulfate, a metal hydrogen sulfate, and a metal borate; metal salts of organic acids such as a metal acetate, a metal stearate, a metal oxalate, and a metal tartrate; metal complexes such as a cyclopentadienyl metal complex (e.g., titanocene) and a cyanometal complex (e.g., Prussian blue); layered clay compounds; crosslinking agents; polymer compounds other than the polymer (G1) and the polymer (G2); plasticizers; antioxidants; ultraviolet absorbers; and flame retardants. The content of the additional component in the layer (W) is preferably 50 mass% or less, more preferably 20 mass% or less, even more preferably 10 mass% or less, and particularly preferably 5 mass% or less, and may be 0 mass% (which means that the additional component is not contained). The layer (W) does not include at least one of the metal oxide (A), the phosphorus compound (B), and the cations (Z). Typically, the layer (W) does not include at least the metal oxide (A).

In terms of achieving good appearance of the multilayer structure, the content of the polymer (G2) in the layer (W) is preferably 85 mass% or less, more preferably 50 mass% or less, even more preferably 20 mass% or less, and particularly preferably 10 mass% or less, with respect to the mass of the layer (W) (defined as 100 mass%). The polymer (G2) may or may not react with another component in the layer (W). The mass ratio between the polymer (G1) and the polymer (G2), as expressed by polymer (G1) : polymer (G2), is preferably in the range of 15 : 85 to 100 : 0 and more preferably in the range of 15 : 85 to 99 : 1.

It is preferable for the thickness of one layer (W) to be 0.003 µm or more, in terms of better resistance of the multilayer structure of the present invention to physical stresses (e.g., bending). The upper limit of the thickness of the layer (W) is not particularly defined; however, the improving effect on resistance to physical stresses reaches a plateau when the thickness of the layer (W) exceeds 1.0 µm. Hence, it is preferable to set the upper limit of the (total) thickness of the layer(s) (W) to 1.0 µm in terms of economic efficiency. The thickness of the layer (W) can be controlled depending on the concentration of the later-described second coating liquid (V) used for forming the layer (W) or the method for applying the liquid (V).

### [Method for producing multilayer structure]

With the production method of the present invention, the multilayer structure of the present invention can easily be produced. The features described for the multilayer structure of the present invention can be applied to the production method of the present invention and may not be described repeatedly. The features described for the production method of the present invention can be applied to the multilayer structure of the present invention.

The method of the present invention for producing a multilayer structure includes the steps [I], [II], and [III]. In the step [I], the metal oxide (A), the phosphorus compound (B), and the ionic compound (E) containing the cations (Z) are mixed to prepare the first coating liquid (U) containing the metal oxide (A), the phosphorus compound (B), and the cations (Z). In the step [II], the first coating liquid (U) is applied onto the base (X) to form a precursor layer of the layer (Y) on the base (X). In the step [III], the precursor layer is heat-treated at a temperature of 110°C or higher to form the layer (Y) on the base (X).

### [Step [I] (Preparation of first coating liquid (U))]

In the step [I], the metal oxide (A), the phosphorus compound (B), and the ionic compound (E) containing the cations (Z) are mixed. In mixing of these compounds, a solvent may be added. The cations (Z) are produced from the ionic compound (E) in the first coating liquid (U). The first coating liquid (U) may include another compound in addition to the metal oxide (A), the phosphorus compound (B), and the cations (Z).

It is preferable that N_{M} and N_{P} satisfy the relational expression given above in the first coating liquid (U). It is preferable that N_{M}, N_{Z}, and F_{Z} satisfy the relational expression given above. It is preferable that Nₚ, N_{Z}, and F_{Z} satisfy the relational expression given above.

It is preferable for the step [I] to include the following steps [I-a] to [I-c].
Step [I-a]: Step of preparing a liquid containing the metal oxide (A).
Step [I-b]: Step of preparing a solution containing the phosphorus compound (B).
Step [I-c]: Step of mixing the metal oxide (A)-containing liquid obtained in the step [I-a] and the phosphorus compound (B)-containing solution obtained in the step [I-b].

The step [I-b] may be performed either before or after the step [I-a] and may be performed simultaneously with the step [I-a]. Hereinafter, each step will be described more specifically.

In the step [I-a], a liquid containing the metal oxide (A) is prepared. The liquid is a solution or a dispersion. The liquid can be prepared, for example, by mixing the compound (L) described above, water, and optionally an acid catalyst and/or an organic solvent and subjecting the compound (L) to condensation or hydrolytic condensation in accordance with procedures employed in commonly-known sol-gel processes. When a dispersion of the metal oxide (A) is obtained by condensation or hydrolytic condensation of the compound (L), the dispersion may be subjected to a particular process (such as deflocculation as mentioned above or addition or removal of the solvent for concentration control) where necessary. The step [I-a] may include a step of subjecting at least one selected from the group consisting of the compound (L) and a hydrolysate of the compound (L) to condensation (e.g., dehydration condensation). The type of the organic solvent that can be used in the step [I-a] is not particularly limited. Preferred examples include alcohols such as methanol, ethanol, and isopropanol, water, and mixed solvents thereof. The content of the metal oxide (A) in the liquid is preferably in the range of 0.1 to 30 mass%, more preferably in the range of 1 to 20 mass%, and even more preferably in the range of 2 to 15 mass%.

For example, when the metal oxide (A) is aluminum oxide, the preparation of a dispersion of aluminum oxide is started by subjecting an aluminum alkoxide to hydrolytic condensation in an aqueous solution whose pH has optionally been adjusted with an acid catalyst, thus yielding a slurry of aluminum oxide. Next, the slurry is deflocculated in the presence of a particular amount of acid to obtain the dispersion of aluminum oxide. A dispersion of a metal oxide (A) that contains atoms of a metal other than aluminum can be produced in the same manner. Preferred examples of the acid include hydrochloric acid, sulfuric acid, nitric acid, acetic acid, lactic acid, and butyric acid. More preferred are nitric acid and acetic acid.

In the step [I-b], a solution containing the phosphorus compound (B) is prepared. The solution can be prepared by dissolving the phosphorus compound (B) in a solvent. When the solubility of the phosphorus compound (B) is low, the dissolution may be promoted by heating or ultrasonication. The solvent may be selected as appropriate depending on the type of the phosphorus compound (B). It is preferable for the solvent to include water. The solvent may include an organic solvent (e.g., methanol) as long as the organic solvent does not hinder the dissolution of the phosphorus compound (B).

The content of the phosphorus compound (B) in the phosphorus compound (B)-containing solution is preferably in the range of 0.1 to 99 mass%, more preferably in the range of 45 to 95 mass%, and even more preferably in the range of 55 to 90 mass%.

In the step [I-c], the metal oxide (A)-containing liquid and the phosphorus compound (B)-containing solution are mixed. Maintaining the temperature at 30°C or lower (e.g., at 20°C) during mixing may lead to successful preparation of the first coating liquid (U) that has good storage stability.

The compound (E) containing the cations (Z) may be added in at least one step selected from the group consisting of the step [I-a], step [I-b], and step [I-c] or in only one of these steps. For example, the compound (E) may be added to the metal oxide (A)-containing liquid prepared in the step [I-a], may be added to the phosphorus compound (B)-containing solution prepared in the step [I-b], or may be added to the liquid mixture prepared by mixing the metal oxide (A)-containing liquid and the phosphorus compound (B)-containing solution in the step [I-c].

Furthermore, the first coating liquid (U) may contain the polymer (C). The method for having the polymer (C) contained in the first coating liquid (U) is not particularly limited. For example, a solution of the polymer (C) may be added to and mixed with any of the metal oxide (A)-containing liquid, the phosphorus compound (B)-containing solution, and the liquid mixture thereof. Alternatively, a powder or pellet of the polymer (C) may be added to and then dissolved in any of the metal oxide (A)-containing liquid, the phosphorus compound (B)-containing solution, and the liquid mixture thereof. When the polymer (C) is contained in the phosphorus compound (B)-containing solution, the rate of reaction between the metal oxide (A) and the phosphorus compound (B) is slowed during the mixing of the metal oxide (A)-containing liquid and the phosphorus compound (B)-containing solution, with the result that the first coating liquid (U) that is superior in temporal stability may be obtained.

The first coating liquid (U) may contain at least one acid compound (J) selected from hydrochloric acid, nitric acid, acetic acid, trifluoroacetic acid, and trichloroacetic acid where necessary. The content of the acid compound (J) is preferably in the range of 0.1 to 5.0 mass% and more preferably in the range of 0.5 to 2.0 mass%. When the content is in such a range, the addition of the acid compound (J) exerts a beneficial effect, and the removal of the acid compound (J) is easy. If any acid component remains in the metal oxide (A)-containing liquid, the amount of the acid compound (J) to be added may be determined in consideration of the amount of the remaining acid component.

The liquid mixture obtained in the step [I-c] can be used per se as the first coating liquid (U). In this case, it is usual that the solvent contained in the metal oxide (A)-containing liquid or the phosphorus compound (B)-containing solution serves as the solvent of the first coating liquid (U). Alternatively, the first coating liquid (U) may be prepared by subjecting the liquid mixture to a process such as addition of an organic solvent, adjustment of pH, adjustment of viscosity, or addition of an additive. Examples of the organic solvent include the solvent used in the preparation of the phosphorus compound (B)-containing solution.

In terms of the storage stability of the first coating liquid (U) and the performance of the first coating liquid (U) in its application onto the base (X), the solids concentration in the first coating liquid (U) is preferably in the range of 1 to 20 mass%, more preferably in the range of 2 to 15 mass%, and even more preferably in the range of 3 to 10 mass%. The solids concentration in the first coating liquid (U) can be determined as follows, for example: A given amount of the first coating liquid (U) was put in a petri dish, the first coating liquid (U) was heated together with the petri dish to remove a volatile component such as the solvent, and the mass of the remaining solids is divided by the mass of the first coating liquid (U) initially put in the dish.

The viscosity of the first coating liquid (U), as measured with a Brookfield rotary viscometer (SB-type viscometer: Rotor No. 3, Rotational speed = 60 rpm), is preferably 3,000 mPa•s or less, more preferably 2,500 mPa•s or less, and even more preferably 2,000 mPa•s or less at a temperature at which the first coating liquid (U) is applied. With the thus-measured viscosity being 3,000 mPa•s or less, the leveling of the first coating liquid (U) is high, and thus the resulting multilayer structure can have better appearance. The viscosity of the first coating liquid (U) is preferably 50 mPa•s s or more, more preferably 100 mPa•s s or more, and even more preferably 200 mPa•s s or more.

In the first coating liquid (U), N_{M} and N_{P} satisfy a relationship of 0.8 ≤ N_{M}/N_{P} ≤ 4.5. In the first coating liquid (U), N_{M}, N_{Z}, and F_{Z} satisfy a relationship of 0.001 ≤ F_{Z} × N_{Z}/N_{M} ≤ 0.60. It is preferable that, in the first coating liquid (U), F_{Z}, N_{Z}, and N_{P} satisfy a relationship of 0.0008 ≤ F_{Z} × N_{Z}/N_{P} ≤ 1.35.

### [Step [II] (Application of first coating liquid (U))]

In the step [II], the first coating liquid (U) is applied onto the base (X) to form a precursor layer of the layer (Y) on the base (X). The first coating liquid (U) may be applied directly onto at least one surface of the base (X). Before application of the first coating liquid (U), an adhesive layer (H) may be formed on the surface of the base (X), for example, by treating the surface of the base (X) with a commonly-known anchor coating agent or by applying a commonly-known adhesive to the surface of the base (X).

The method for applying the first coating liquid (U) onto the base (X) is not particularly limited, and any commonly-known method can be used. Examples of the application method include casting, dipping, roll coating, gravure coating, screen printing, reverse coating, spray coating, kiss coating, die coating, metering bar coating, chamber doctor-using coating, and curtain coating.

In the step [II], the formation of the precursor layer of the layer (Y) is accomplished typically by removing the solvent from the first coating liquid (U). The method for removing the solvent is not particularly limited, and any commonly-known drying method can be employed. Examples of the drying method include hot-air drying, heat roll contact drying, infrared heating, and microwave heating. The temperature of the drying treatment is preferably 0 to 15°C or more lower than the onset temperature of fluidization of the base (X). When the first coating liquid (U) contains the polymer (C), the temperature of the drying treatment is preferably 15 to 20°C or more lower than the onset temperature of pyrolysis of the polymer (C). The temperature of the drying treatment is preferably in the range of 70 to 200°C, more preferably in the range of 80 to 180°C, and even more preferably in the range of 90 to 160°C. The removal of the solvent may be performed either at ordinary pressure or at reduced pressure. Alternatively, the solvent may be removed by the heat treatment in the step [III] described later.

When the layers (Y) are stacked on both surfaces of the base (X) that is in the form of a layer, a first layer (a precursor layer of a first layer (Y)) may be formed by application of the first coating liquid (U) onto one surface of the base (X) followed by removal of the solvent, and then a second layer (a precursor layer of a second layer (Y)) may be formed by application of the first coating liquid (U) onto the other surface of the base (X) followed by removal of the solvent. The composition of the first coating liquid (U) applied may be the same for both of the surfaces or may be different for each surface.

### [Step [III] (Treatment of precursor layer of layer (Y))]

In the step [III], the precursor layer (precursor layer of the layer (Y)) formed in the step [II] is heat-treated at a temperature of 140°C or higher to form the layer (Y). The temperature of this heat treatment is preferably higher than the temperature of the drying treatment subsequent to the application of the first coating liquid (U).

In the step [III], a reaction takes place in which pieces of the metal oxide (A) are bonded together via phosphorus atoms (phosphorus atoms derived from the phosphorus compound (B)). From another standpoint, a reaction of formation of the reaction product (D) takes place in the step [III]. In order for the reaction to take place to a sufficient extent, the temperature of the heat treatment is preferably 140°C or higher, more preferably 170°C or higher, and even more preferably 180°C or higher. A lowered temperature of the heat treatment increases the time required to achieve a sufficient degree of reaction, and may cause a reduction in production efficiency. The preferred upper limit of the temperature of the heat treatment varies depending on, for example, the type of the base (X). For example, when a thermoplastic resin film made of polyamide resin is used as the base (X), it is preferable for the temperature of the heat treatment to be 270°C or lower. When a thermoplastic resin film made of polyester resin is used as the base (X), it is preferable for the temperature of the heat treatment to be 240°C or lower. The heat treatment can be performed, for example, in air, in a nitrogen atmosphere, or in an argon atmosphere.

The length of time of the heat treatment is preferably in the range of 0.1 seconds to 1 hour, more preferably in the range of 1 second to 15 minutes, and even more preferably in the range of 5 to 300 seconds.

The method of the present invention for producing a multilayer structure may include a step of irradiating the layer (Y) or the precursor layer of the layer (Y) with ultraviolet light. The ultraviolet irradiation may be performed, for example, after the step [II] (for example, after the removal of the solvent from the applied first coating liquid (U) is almost completed).

To place the adhesive layer (H) between the base (X) and the layer (Y), a surface of the base (X) may be treated with a commonly-known anchor coating agent, or a commonly-known adhesive may be applied to a surface of the base (X), before application of the first coating liquid (U).

The method of the present invention for producing a multilayer structure may further include the steps [i] and [ii]. In the step [i], the second coating liquid (V) including the polymer (G1) containing a phosphorus atom and a solvent is prepared. In the step [ii], the layer (W) placed contiguous to the layer (Y) is formed using the second coating liquid (V). There is no particular limitation on when the step [i] is done. The step [i] may be performed concurrently with the step [I], [II], or [III] or may be performed after the step [I], [II], or [III]. The step [ii] can be performed after the step [II] or [III]. The layer (W) stacked on the layer (Y) so as to be in contact with the layer (Y) can be formed by applying the second coating liquid (V) to the layer (Y) or the precursor layer of the layer (Y). When the layer (W) including the polymer (G2) is to be formed, the second coating liquid (V) should contain the polymer (G2). In the second coating liquid (V), the mass ratio between the polymer (G1) and the polymer (G2), as expressed by polymer (G1) : polymer (G2), is preferably in the range of 15 : 85 to 100 : 0 and more preferably in the range of 15 : 85 to 99 : 1. The use of the second coating liquid (V) containing the polymer (G1) and the polymer (G2) at such a mass ratio allows the formation of the layer (W) in which the mass ratio between the polymer (G1) and the polymer (G2) is within the range. The second coating liquid (V) can be prepared by dissolving the polymer (G1) (and optionally the polymer (G2)) in a solvent.

The solvent used in the second coating liquid (V) may be selected as appropriate depending on the type(s) of the polymer(s) to be contained in the liquid. Preferred are water, alcohols, and mixed solvents thereof. As long as the dissolution of the polymer(s) is not hindered, the solvent may include: an ether such as tetrahydrofuran, dioxane, trioxane, or dimethoxyethane; a ketone such as acetone or methyl ethyl ketone; a glycol such as ethylene glycol or propylene glycol; a glycol derivative such as methyl cellosolve, ethyl cellosolve, or n-butyl cellosolve; glycerin; acetonitrile; an amide such as dimethylformamide; dimethyl sulfoxide; and/or sulfolane.

The concentration of the solids (such as the polymer (G1)) in the second coating liquid (V) is preferably in the range of 0.01 to 60 mass%, more preferably in the range of 0.1 to 50 mass%, and even more preferably in the range of 0.2 to 40 mass%, in terms of the storage stability and coating properties of the liquid. The solids concentration can be determined in the same manner as described for the first coating liquid (U).

In the step [ii], the formation of the layer (W) is accomplished typically by removing the solvent from the second coating liquid (V). The method for removing the solvent from the second coating liquid (V) is not particularly limited, and any commonly-known drying method can be employed. Examples of the drying method include hot-air drying, heat roll contact drying, infrared heating, and microwave heating. The drying temperature is preferably 0 to 15°C or more lower than the onset temperature of fluidization of the base (X). The drying temperature is preferably in the range of 70 to 200°C and more preferably in the range of 150 to 200°C. The removal of the solvent may be performed either at ordinary pressure or at reduced pressure. When the step [ii] is performed between the step [II] and step [III] previously described, the solvent may be removed by the heat treatment in the step [III].

The layers (W) may be formed on both sides of the base (X), with the layers (Y) interposed therebetween. In an exemplary case, a first layer (W) is formed by application of the second coating liquid (V) on one side followed by removal of the solvent. Next, a second layer (W) is formed by application of the second coating liquid (V) on the other side followed by removal of the solvent. The composition of the second coating liquid (V) applied may be the same for both sides or may be different for each side.

A multilayer structure obtained as a result of the heat treatment in the step [III] can be used per se as the multilayer structure of the present invention. As previously described, however, another member (e.g., an additional layer) may be attached to or formed on the multilayer structure obtained as a result of the heat treatment in the step [III], and the resulting layered product may be used as the multilayer structure of the present invention. The attachment of the member can be done by a commonly-known method.

### [Extrusion coating lamination]

The multilayer structure of the present invention can further include a layer formed by extrusion coating lamination; that is, after the layer (Y) (and optionally the layer (W)) is stacked on the base (X) directly or with the adhesive layer (H) interposed therebetween, an additional layer may be formed by extrusion coating lamination on the layer (Y) or (W) directly or with the adhesive layer (H) interposed therebetween. The method for extrusion coating lamination that can be used in the present invention is not particularly limited, and a commonly-known method may be used. In a typical method for extrusion coating lamination, a molten thermoplastic resin is fed to a T-die, and the thermoplastic resin extruded through a flat slit of the T-die is cooled to produce a laminated film.

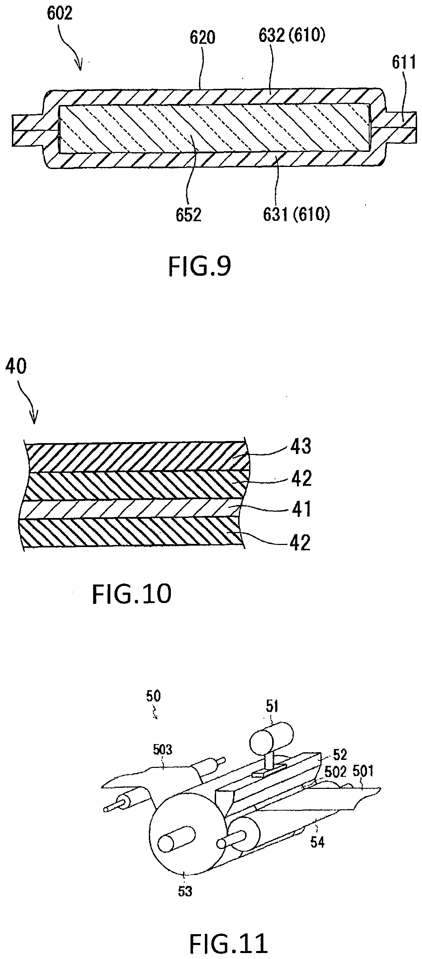

An example of single lamination, which is the most common method for extrusion coating lamination, will now be described with reference to the drawings. An example of the apparatus used in single lamination is shown in FIG. 11. FIG. 11 schematically shows only a key part of the apparatus, and actual apparatuses are different from that shown in FIG. 11. The apparatus 50 shown in FIG. 11 includes an extruder 51, a T-die 52, a cooling roll 53, and a rubber roll 54. The cooling roll 53 and the rubber roll 54 are arranged in such a manner that their roll surfaces are in contact with each other.

A thermoplastic resin is heated and melted in the extruder, and then extruded through the flat slit of the T-die 52 into a resin film 502. This resin film 502 is a layer containing the thermoplastic resin. Meanwhile, a layered product 501 is delivered from a sheet feeder (not shown) and is pressed, together with the resin film 502, between the cooling roll 53 and the rubber roll 54. The layered product 501 and the resin film 502, stacked on each other, are pressed together between the cooling roll 53 and the rubber roll 54 to produce a laminated film (multilayer structure) 503 including the layered product 501 and the resin film 502 united together.

Examples of the method for extrusion coating lamination other than the above single lamination include sandwich lamination and tandem lamination. The sandwich lamination is a method in which a molten thermoplastic resin is extruded onto a first base supplied from an unwinder (feed roll) and is laminated to a second base supplied from another unwinder. The tandem lamination is a method in which two single-lamination machines connected together are used to produce a layered product consisting of five layers at a time.

The use of the layered product previously described allows fabrication of a multilayer structure that maintains high barrier performance even after extrusion coating lamination.

### [Adhesive layer (H)]

In the multilayer structure of the present invention, the layer (Y) may be stacked in direct contact with the base (X). Alternatively, the layer (Y) may be stacked above the base (X), with another layer interposed therebetween. For example, the layer (Y) may be stacked above the base (X), with the adhesive layer (H) interposed therebetween. With this configuration, the adhesion between the base (X) and the layer (Y) may be enhanced. The adhesive layer (H) may be formed from an adhesive resin. The adhesive layer (H) made of an adhesive resin can be formed by treating a surface of the base (X) with a commonly-known anchor coating agent or by applying a commonly-known adhesive to a surface of the base (X). The adhesive is preferably a two-component reactive polyurethane adhesive including a polyisocyanate component and a polyol component which are to be mixed and reacted. The addition of a small amount of additive such as a commonly-known silane coupling agent to the anchor coating agent or adhesive may further enhance the adhesion. Examples of the silane coupling agent include, but are not limited to, silane coupling agents having a reactive group such as an isocyanate, epoxy, amino, ureido, or mercapto group. Strong adhesion between the base (X) and the layer (Y) via the adhesive layer (H) makes it possible to more effectively prevent deterioration in the barrier properties and appearance of the multilayer structure of the present invention when the multilayer structure is subjected to a process such as printing or lamination, and also increase the drop impact resistance of a packaging material including the multilayer structure of the present invention. The thickness of the adhesive layer (H) is preferably 0.01 to 10.0 µm and more preferably 0.03 to 5.0 µm.

### [Additional layer]

The multilayer structure of the present invention may include an additional layer for imparting various properties such as heat-sealing properties or for improving the barrier properties or mechanical properties. Such a multilayer structure of the present invention can be formed, for example, by stacking the layer (Y) on the base (X) directly or with the adhesive layer (H) interposed therebetween and then attaching or forming the additional layer on the layer (Y) directly or with the adhesive layer (H) interposed therebetween. Examples of the additional layer include, but are not limited to, an ink layer and a polyolefin layer.

The multilayer structure of the present invention may include an ink layer on which a product name or a decorative pattern is to be printed. Such a multilayer structure of the present invention can be produced, for example, by stacking the layer (Y) on the base (X) directly or with the adhesive layer (H) interposed therebetween and then forming the ink layer directly on the layer (Y). Examples of the ink layer include a film resulting from drying of a liquid prepared by dispersing a polyurethane resin containing a pigment (e.g., titanium dioxide) in a solvent. The ink layer may be a film resulting from drying of an ink or electronic circuit-forming resist containing a polyurethane resin free of any pigment or another resin as a main component. Methods that can be used to apply the ink layer onto the layer (Y) include gravure printing and various coating methods using a wire bar, a spin coater, or a die coater. The thickness of the ink layer is preferably 0.5 to 10.0 µm and more preferably 1.0 to 4.0 µm.

When the multilayer structure of the present invention includes the layer (W) that contains the polymer (G2), the adhesion between the layer (W) and another layer such as the adhesive layer (H) or the additional layer (e.g., the ink layer) is improved by virtue of the polymer (G2) having a functional group with high affinity to said another layer. This enables the multilayer structure to maintain its barrier performance after being exposed to physical stresses such as that caused by a stretching process and can prevent the multilayer structure from suffering from an appearance defect such as delamination.

When a polyolefin layer is placed as an outermost layer of the multilayer structure of the present invention, heat-sealing properties can be imparted to the multilayer structure, or the mechanical characteristics of the multilayer structure can be improved. In terms of, for example, the impartation of heat-sealing properties and the improvement in mechanical characteristics, the polyolefin is preferably polypropylene or polyethylene. It is also preferable to stack at least one film selected from the group consisting of a film made of a polyester, a film made of a polyamide, and a film made of a hydroxy group-containing polymer, in order to improve the mechanical characteristics of the multilayer structure. In terms of the improvement in mechanical characteristics, the polyester is preferably polyethylene terephthalate, the polyamide is preferably nylon-6, and the hydroxy group-containing polymer is preferably ethylene-vinyl alcohol copolymer. Between the layers there may be provided an anchor coat layer or a layer made of an adhesive where necessary.

### [Configuration of multilayer structure]

Specific examples of the configuration of the multilayer structure of the present invention are listed below. The multilayer structure may have an adhesive layer such as the adhesive layer (H); however, the adhesive layer and the additional layer are omitted in the following list of specific examples.
(1) Layer (Y)/polyester layer,
(2) Layer (Y)/polyester layer/layer (Y),
(3) Layer (Y)/polyamide layer,
(4) Layer (Y)/polyamide layer/layer (Y),
(5) Layer (Y)/polyolefin layer,
(6) Layer (Y)/polyolefin layer/layer (Y),
(7) Layer (Y)/hydroxy group-containing polymer layer,
(8) Layer (Y)/hydroxy group-containing polymer layer/layer (Y),
(9) Layer (Y)/paper layer,
(10) Layer (Y)/paper layer/layer (Y),
(11) Layer (Y)/inorganic deposited layer/polyester layer,
(12) Layer (Y)/inorganic deposited layer/polyamide layer,
(13) Layer (Y)/inorganic deposited layer/polyolefin layer,
(14) Layer (Y)/inorganic deposited layer/hydroxy group-containing polymer layer,
(15) Layer (Y)/polyester layer/polyamide layer/polyolefin layer,
(16) Layer (Y)/polyester layer/layer (Y)/polyamide layer/polyolefin layer,
(17) Polyester layer/layer (Y)/polyamide layer/polyolefin layer,
(18) Layer (Y)/polyamide layer/polyester layer/polyolefin layer,
(19) Layer (Y)/polyamide layer/layer (Y)/polyester layer/polyolefin layer,
(20) Polyamide layer/layer (Y)/polyester layer/polyolefin layer,
(21) Layer (Y)/polyolefin layer/polyamide layer/polyolefin layer,
(22) Layer (Y)/polyolefin layer/layer (Y)/polyamide layer/polyolefin layer,
(23) Polyolefin layer/layer (Y)/polyamide layer/polyolefin layer,
(24) Layer (Y)/polyolefin layer/polyolefin layer,
(25) Layer (Y)/polyolefin layer/layer (Y)/polyolefin layer,
(26) Polyolefin layer/layer (Y)/polyolefin layer,
(27) Layer (Y)/polyester layer/polyolefin layer,
(28) Layer (Y)/polyester layer/layer (Y)/polyolefin layer,
(29) Polyester layer/layer (Y)/polyolefin layer,
(30) Layer (Y)/polyamide layer/polyolefin layer,
(31) Layer (Y)/polyamide layer/layer (Y)/polyolefin layer,
(32) Polyamide layer/layer (Y)/polyolefin layer,
(33) Layer (Y)/polyester layer/paper layer,
(34) Layer (Y)/polyamide layer/paper layer,
(35) Layer (Y)/polyolefin layer/paper layer,
(36) Polyolefin layer/paper layer/polyolefin layer/layer (Y)/polyester layer/polyolefin layer,
(37) Polyolefin layer/paper layer/polyolefin layer/layer (Y)/polyamide layer/polyolefin layer,
(38) Polyolefin layer/paper layer/polyolefin layer/layer (Y)/polyolefin layer,
(39) Paper layer/polyolefin layer/layer (Y)/polyester layer/polyolefin layer,
(40) Polyolefin layer/paper layer/layer (Y)/polyolefin layer,
(41) Paper layer/layer (Y)/polyester layer/polyolefin layer,
(42) Paper layer/layer (Y)/polyolefin layer,
(43) Layer (Y)/paper layer/polyolefin layer,
(44) Layer (Y)/polyester layer/paper layer/polyolefin layer,
(45) Polyolefin layer/paper layer/polyolefin layer/layer (Y)/polyolefin layer/hydroxy group-containing polymer layer,
(46) Polyolefin layer/paper layer/polyolefin layer/layer (Y)/polyolefin layer/polyamide layer,
(47) Polyolefin layer/paper layer/polyolefin layer/layer (Y)/polyolefin layer/polyester layer,
(48) Inorganic deposited layer/layer (Y)/polyester layer,
(49) Inorganic deposited layer/layer (Y)/polyester layer/layer (Y)/inorganic deposited layer,
(50) Inorganic deposited layer/layer (Y)/polyamide layer,
(51) Inorganic deposited layer/layer (Y)/polyamide layer/layer (Y)/inorganic deposited layer,
(52) Inorganic deposited layer/layer (Y)/polyolefin layer,
(53) Inorganic deposited layer/layer (Y)/polyolefin layer/layer (Y)/inorganic deposited layer

When the multilayer structure of the present invention is used in a protective sheet for electronic devices, any of the configurations (1) to (8), (11) to (32), and (48) to (53) among the above-listed configurations is preferred.

### [Applications]

The multilayer structure of the present invention is superior in both gas barrier properties and water vapor barrier properties and is capable of maintaining both of the barrier properties at high levels even after being exposed to physical stresses such as stretching during processing and bending that occurs during heat sealing or retorting due to the difference in thermal contraction coefficient between the base (X) and the layer (Y). Furthermore, according to a preferred example of the present invention, a multilayer structure having good appearance can be obtained. The multilayer structure of the present invention and a packaging material including the multilayer structure can therefore be used in various applications.

### [Packaging material]

A packaging material of the present invention includes a multilayer structure including the base (X) and the layer (Y) stacked on the base (X). The packaging material may consist only of the multilayer structure. That is, in the following description, the term "packaging material" may be interchanged with the term "multilayer structure". In addition, the term "packaging material" is typically interchangeable with the term "package". The packaging material may be composed of the multilayer structure and another member.

The packaging material according to a preferred embodiment of the present invention has barrier properties against inorganic gases (such as hydrogen, helium, nitrogen, oxygen, and carbon dioxide), natural gases, water vapor, and organic compounds that are liquid at ordinary temperature and pressure (such as ethanol and gasoline vapor).

When the packaging material of the present invention is in the form of a packaging bag, the multilayer structure may be used over the entirety of the packaging bag or the multilayer structure may be used in a part of the packaging bag. For example, 50% to 100% of the area of the packaging bag may be formed of the multilayer structure. The same applies to the case where the packaging material is in a form other than a packaging bag (in the form of a container or a lid, for example).

The packaging material of the present invention can be fabricated by various methods. For example, a container (packaging material) may be fabricated by subjecting a sheet of the multilayer structure or a film material including the multilayer structure (such a material will hereinafter be simply referred to as "film material") to a joining process and thereby forming the sheet of the multilayer structure or the film material into a predetermined container shape. Examples of the method for shaping include thermoforming, injection molding, and extrusion blow molding. Alternatively, a container (packaging material) may be fabricated by forming the layer (Y) on the base (X) that has been formed in a predetermined container shape. A container thus fabricated may be referred to as a "packaging container" herein.

The packaging material including the multilayer structure of the present invention may be used after being formed into any of various shaped products by secondary processing. A shaped product including such a multilayer structure may be a vertical form-fill-seal bag, a vacuum packaging bag, a spouted pouch, a laminated tube container, an infusion bag, a paper container, a strip tape, a container lid, an in-mold labeled container, or a vacuum insulator. These shaped products may be formed through heat sealing.

### [Vertical form-fill-seal bag]

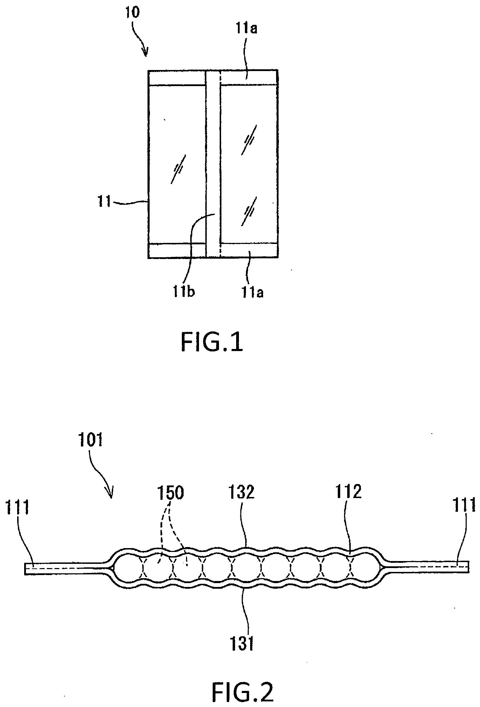

The multilayer structure of the present invention may be in the form of a vertical form-fill-seal bag. An example is shown in FIG. 1. A vertical form-fill-seal bag 10 of FIG. 1 is formed of a multilayer structure 11 sealed at three portions, i.e., two edge portions 11a and a body portion 11b. The vertical form-fill-seal bag 10 can be produced by a vertical form-fill-seal machine. Various methods can be employed for bag making by a vertical form-fill-seal machine. In any method, the substance to be contained in the bag is fed through the top opening of the bag into its interior, and the opening is then sealed to produce the vertical form-fill-seal bag. The vertical form-fill-seal bag is composed of, for example, one film material heat-sealed at three portions, its upper edge, lower edge, and side. The vertical form-fill-seal bag as the packaging container according to the present invention is superior in gas barrier properties and water vapor barrier properties and suffers little deterioration in gas barrier properties and water vapor barrier properties even after being subjected to a bending process involving stretching or to physical stresses such as deformation and impact. The vertical form-fill-seal bag is therefore capable of preventing quality degradation of the contained substance over a long period of time.

### [Vacuum packaging bag]

The packaging material including the multilayer structure of the present invention may be a vacuum packaging bag. An example is shown in FIG. 2. A vacuum packaging bag 101 of FIG. 2 is a container including film materials 131 and 132 as barrier members which are joined (sealed) together at their edges 111. The interior of the hermetically-closed vacuum packaging bag has a reduced pressure and, in general, the central portions 112 of the film materials 131 and 132, which are bounded by the edges 111, are deformed to be in close contact with a substance 150 contained in the bag and function as a separation barrier separating the interior of the bag 101 from the outside. The vacuum packaging bag can be produced using a nozzle-type or chamber-type vacuum packaging machine. The vacuum packaging bag as the packaging container according to the present invention is superior in gas barrier properties and water vapor barrier properties and is adapted to maintain the gas barrier properties and water vapor barrier properties even after being subjected to a bending process involving stretching or to physical stresses such as deformation and impact. The barrier performance of the vacuum packaging bag therefore hardly deteriorates over a long period of time.

### [Pouch]

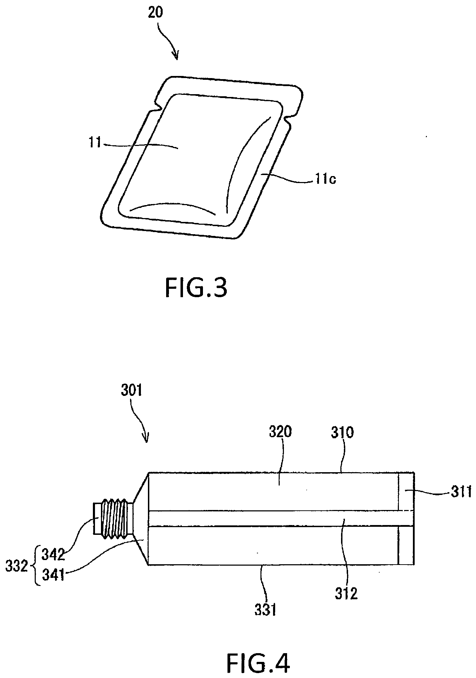

The packaging material including the multilayer structure of the present invention may be a pouch. An example is shown in FIG. 3. A flat pouch 20 of FIG. 3 is formed of two multilayer structures 11 joined together at their edges 11c. The term "pouch" as used herein generally refers to a container including a film material as a barrier member and intended to contain a food, a daily commodity, or a medical product. Pouches can have various shapes and applications, and examples of the pouches include a spouted pouch, a zippered pouch, a flat pouch, a stand-up pouch, a horizontal form-fill-seal pouch, and a retort pouch. Such a pouch may be formed by stacking a multilayer barrier film and at least another layer together. The pouch as the packaging container according to the present invention is superior in gas barrier properties and water vapor barrier properties and maintains the gas barrier properties and water vapor barrier properties even when exposed to physical stresses such as deformation and impact. The pouch is therefore capable of preventing the contained substance from changing in quality after transportation or long-term storage. An example of the pouch can hold good transparency, which allows easy identification of the contained substance and easy check for change in the quality of the contained substance caused by degradation.

### [Laminated tube]

The packaging material including the multilayer structure of the present invention may be a laminated tube container. An example is shown in FIG. 4. A laminated tube container 301 of FIG. 4 includes: a barrel portion 331 including a laminated film 310 as a separation barrier 320 separating the interior of the container from the outside; and a shoulder portion 332. The shoulder portion 332 includes a tubular outlet portion 342 having a through hole (outlet orifice) and a base portion 341 having the shape of a hollow frustum of a cone. More specifically, the laminated tube container includes: the barrel portion 331 that is a tubular portion having one end closed; the shoulder portion 332 placed at the other end of the barrel portion 331; an end sealed portion 311; and a side sealed portion 312, and the shoulder portion 332 includes: the tubular outlet portion 342 having a through hole (outlet orifice) and having a male thread on its outer circumference; and the base portion 341 having the shape of a hollow frustum of a cone. A cap having a female thread fittable to the male thread may be detachably attached to the outlet portion 342. It is preferable for the laminated film 310 forming the barrier member of the barrel portion 331 to have such flexibility as described above for the film material. A shaped component made of metal or resin can be used as the shoulder portion 332. The laminated tube container as the packaging container according to the present invention is superior in gas barrier properties and water vapor barrier properties, suffers little deterioration in gas barrier properties and water vapor barrier properties even after being subjected to a bending process involving stretching or to physical stresses such as deformation and impact, and maintains the good gas barrier properties and water vapor barrier properties even after being squeezed when in use. Also, when the multilayer structure that has good transparency is used in the laminated tube container, it is easy to identify the contained substance or to check for change in the quality of the contained substance caused by degradation.

### [Infusion bag]

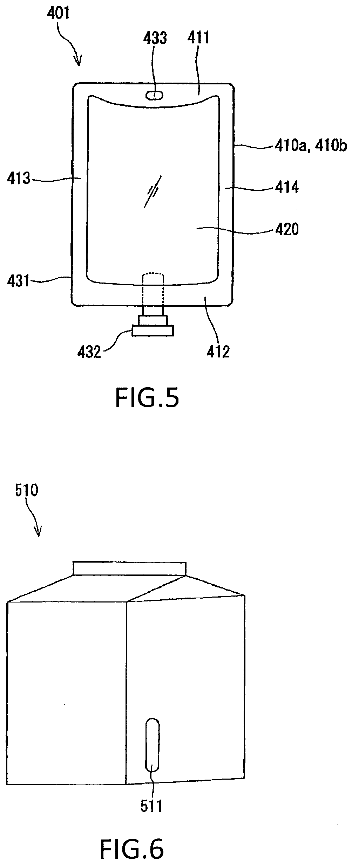

The packaging material including the multilayer structure of the present invention may be an infusion bag. The infusion bag is a container intended to contain an infusion drug and includes the film material as a separation barrier separating the interior for containing the infusion drug from the outside. An example is shown in FIG. 5. As shown in FIG. 5, the infusion bag includes a bag body 431 for containing a substance and may further include a plug member 432 attached at an edge 412 of the bag body 431. The plug member 432 functions as a passage for letting out an infusion contained in the interior of the bag body 431. The infusion bag may include a hanging hole 433 for hanging the bag, the hole being formed in an edge 411 opposite to the edge 412 at which the plug member 432 is attached. The bag body 431 is formed of two film materials 410a and 410b joined together at the edges 411, 412, 413, and 414. The film materials 410a and 410b function together as a separation barrier 420 separating the interior of the bag from the outside of the bag in a central portion of the bag body 431 which is bounded by the edges 411, 412, 413, and 414. The infusion bag as the packaging container according to the present invention is superior in gas barrier properties and water vapor barrier properties and suffers little deterioration in gas barrier properties and water vapor barrier properties even after being subjected to a bending process involving stretching or to physical stresses such as deformation and impact. The infusion bag can therefore prevent the packed liquid medical product from changing in quality before, during, and after heat sterilization, after transportation, and after storage.

### [Paper container]

The packaging material including the multilayer structure of the present invention may be a paper container. The paper container is a container having a separation barrier separating the interior for containing a substance from the outside, the separation barrier including a paper layer. In a preferred example, at least a part of the separation barrier includes a multilayer structure, and the multilayer structure includes the base (X) and the layer (Y). The paper layer may be included in the base (X). The paper container may be formed in a predetermined shape having a bottom such as a shape of the brick type or the gable top type. The paper container as the packaging container according to the present invention suffers little deterioration in gas barrier properties and water vapor barrier properties even when subjected to a folding process. In addition, the paper container can be preferably used as a windowed container by virtue of the layer (Y) having good transparency. An example is shown in FIG. 6. A paper container 510 has a window portion 511 on a side of its body portion. The paper layer has been removed from the base included in the window portion of the windowed container, so that the contained substance can be visually seen through the window portion 511. Also in the window portion 511 from which the paper layer has been removed, the layer configuration of the multilayer structure with improved gas barrier properties remains intact. The paper container 510 of FIG. 6 can be formed by subjecting a flat sheet of layered product to folding and joining (sealing) process. The paper container is also suitable for heating by a microwave oven.

### [Strip tape]

When a paper container is fabricated by subjecting a sheet of layered product to a joining (sealing) process, a strip tape may be used as a portion for sealing of the layered product. The strip tape is a strip-shaped member used to join together portions of a barrier member (layered product) constituting a separation barrier of the paper container. The paper container according to the present invention may include the strip tape at a bonding portion at which portions of the layered product are joined together. In this case, the strip tape may include a multilayer structure having the same layer configuration as the multilayer structure included in the separation barrier of the paper container. In a preferred example of the strip tape, both of the outermost layers are polyolefin layers adapted for heat sealing. Such a strip tape can serve to prevent the property deterioration at the bonding portion where the gas barrier properties or water vapor barrier properties are prone to deterioration. This strip tape is therefore useful also for a paper container that does not fall under the category of the packaging container according to the present invention.

### [Container lid]

The packaging material including the multilayer structure of the present invention may be a container lid. The container lid includes the film material functioning as a part of a separation barrier separating the interior of a container from the outside of the container. The container lid is combined with a container body, for example, by a joining (sealing) process using heat sealing or an adhesive in such a manner as to close an opening portion of the container body. A container (lidded container) having a hermetically-closed internal space is thus formed. The container lid is joined to the container body typically at its edges. In this case, the central portion bounded by the edges faces the internal space of the container. The container body may be, for example, a shaped body having a cup shape, a tray shape, or another shape. The container body includes, for example, a wall portion and a flange portion for sealing of the container lid. The container lid as the packaging material according to the present invention is superior in gas barrier properties and water vapor barrier properties and suffers little deterioration in gas barrier properties and water vapor barrier properties even after being subjected to a bending process involving stretching, thus being capable of preventing quality degradation of the contained substance such as a food over a long period of time.

### [In-mold labeled container]

The packaging material including the multilayer structure of the present invention may be an in-mold labeled container. The in-mold labeled container includes a container body and a multilayer label (multilayer structure) according to the present invention which is provided on the surface of the container body. The container body is formed through injection of a molten resin into a mold. The shape of the container body is not particularly limited, and may be a cup shape or a bottle shape, for example.

An example of the method for producing the container according to the present invention includes: a first step of placing a multilayer label of the present invention in a cavity between a female mold member and a male mold member; and a second step of injecting a molten resin into the cavity to perform molding of a container body and lamination of the multilayer label of the present invention to the container body simultaneously. Each step can be carried out in the same manner as in commonly-known methods, except for using the multilayer label of the present invention.

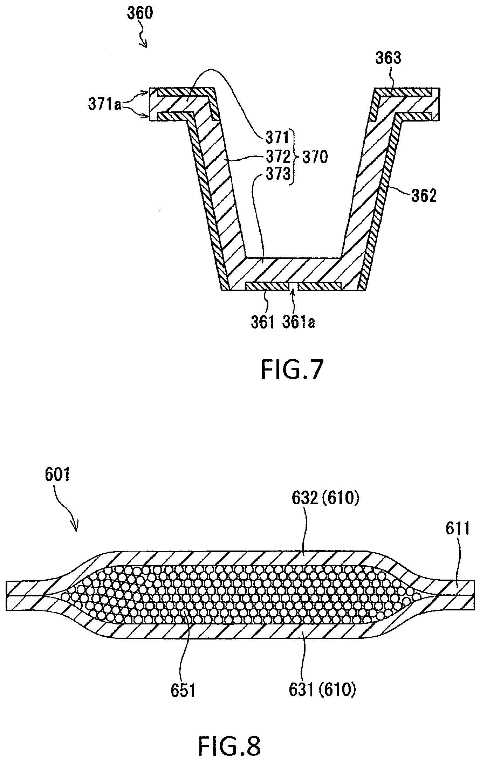

A cross-sectional view of an example of the container of the present invention is shown in FIG. 7. A container 360 of FIG. 7 includes a cup-shaped container body 370 and multilayer labels 361 to 363 laminated to the surface of the container body 370. The multilayer labels 361 to 363 are each the multilayer label of the present invention. The container body 370 includes a flange portion 371, a body portion 372, and a bottom portion 373. The flange portion 371 has at its edges projections 371a projecting upwardly and downwardly. The multilayer label 361 is placed to cover the outer surface of the bottom portion 373. At the center of the multilayer label 361 there is formed a through hole 361a for injecting a resin in the in-mold labeling molding. The multilayer label 362 is placed to cover the outer surface of the body portion 372 and the under surface of the flange portion 371. The multilayer label 363 is placed to cover a part of the inner surface of the body portion 372 and the top surface of the flange portion 371. The multilayer labels 361 to 363 are fused with the container body 370 and united with the container body 360 by in-mold labeling molding. As shown in FIG. 7, the edge surfaces of the multilayer label 363 are fused with the container body 360 and are not exposed to the outside.

### [Vacuum insulator]

A vacuum insulator is a heat insulator including a sheath material and a core material placed in an interior bounded by the sheath material, and the interior in which the core material is placed has a reduced pressure. A vacuum insulator thinner and lighter than an insulator made of urethane foam can provide heat insulating properties comparable to the heat insulating properties provided by the urethane foam insulator. The vacuum insulator of the present invention is capable of maintaining the heat-insulating effect over a long period of time and can therefore be used, for example, as or in: a heat insulating material for home electric appliances such as refrigerators, hot-water supply systems, and rice cookers; a residential heat insulating material used in walls, ceilings, attics, floors, etc.; a vehicle roof member; an insulating panel for automatic vending machines etc.; and a heat transfer apparatus such as an apparatus employing a heat pump.

An example of the vacuum insulator according to the present invention is shown in FIG. 8. A vacuum insulator 601 of FIG. 8 includes a sheath material 610 and a core material 651 in the form of particles. The sheath material 610 is composed of two film materials 631 and 632 joined together at their edges 611, and the core material 651 is placed in an interior bounded by the sheath material 610. In the central portion bounded by the edges 611, the sheath material 610 functions as a separation barrier separating the interior containing the core material 651 from the outside and, due to pressure difference between the interior and the outside, is in close contact with the core material 651.

Another example of the vacuum insulator according to the present invention is shown in FIG. 9. The vacuum insulator 602 has the same configuration as the vacuum insulator 601, except for including, instead of the core material 651, a core material 652 formed as a single body. The core material 652 is typically a foamed resin.

The component and form of the core material are not particularly limited as long as they are adapted for heat insulation. Examples of the core material include a pearlite powder, a silica powder, a precipitated silica powder, diatomite, calcium silicate, glass wool, rockwool, artificial (synthetic) wool, and foamed resins (such as styrene foam and urethane foam). As the core material there can also be used a hollow container or a honeycomb structure formed in a predetermined shape.

### [Electronic device]

An exemplary electronic device having a protective sheet of the present invention will now be described. A partial cross-sectional view of the electronic device is shown in FIG. 10. The electronic device 40 of FIG. 10 includes an electronic device body 41, a sealing member 42 for sealing the electronic device body 41, and a protective sheet (multilayer structure) 43 for protecting the surface of the electronic device body 41. The sealing member 42 covers the entire surface of the electronic device body 41. The protective sheet 43 is formed on one side of the electronic device body 41, with the sealing member 42 interposed therebetween. On the side opposite to that on which the protective sheet 43 is placed there may be placed another protective sheet. In this case, the protective sheet placed on the opposite side may be the same as or different from the protective sheet 43.

The electronic device body 41 is not particularly limited and is, for example, a photoelectric conversion device such as a solar cell, an information display device such as an organic EL display, liquid crystal display, or electronic paper, or a lighting device such as an organic EL light-emitting element. The sealing member 42 is an optional member which is added as appropriate depending on, for example, the type and use of the electronic device body 41. Examples of the sealing member 42 include ethylene-vinyl acetate copolymer and polyvinyl butyral. It suffices for the protective sheet 43 to be placed in such a manner as to protect the surface of the electronic device body 41. The protective sheet 43 may be placed directly on the surface of the electronic device body 41 or may be placed over the surface of the electronic device body 41, with another member such as the sealing member 42 being interposed therebetween.

A preferred example of the electronic device body 41 is a solar cell. Examples of the solar cell include a silicon solar cell, a compound semiconductor solar cell, and an organic thin-film solar cell. Examples of the silicon solar cell include a monocrystalline silicon solar cell, a polycrystalline silicon solar cell, and an amorphous silicon solar cell. Examples of the compound semiconductor solar cell include a III-V compound semiconductor solar cell, a II-VI compound semiconductor solar cell, and a I-III-VI compound semiconductor solar cell. Examples of the organic thin-film solar cell include a p-n heterojunction organic thin-film solar cell and a bulk heterojunction organic thin-film solar cell. The solar cell may be an integrated solar cell including a plurality of unit cells connected in series.

Depending on the type of the electronic device body 41, it can be fabricated by a so-called roll-to-roll process. In the roll-to-roll process, a flexible substrate (e.g., a stainless steel substrate or a resin substrate) wound around a feed roll is delivered from the feed roll, an element is formed on this substrate to fabricate the electronic device body 41, and the electronic device body 41 is wound on a take-up roll. In this case, it is advantageous that the protective sheet 43 be prepared beforehand in the form of a flexible long sheet, more particularly in the form of a wound roll of the long sheet. In an example, the protective sheet 43 delivered from a feed roll is laminated onto the electronic device body 41 that has yet to be wound on the take-up roll and is wound up together with the electronic device body 41. In another example, the electronic device body 41 that has been wound on the take-up roll once is fed from the roll again and laminated to the protective sheet 43. In a preferred example of the present invention, the electronic device per se has flexibility.

The protective sheet 43 includes the multilayer structure described above. The protective sheet 43 may consist only of the multilayer structure. Alternatively, the protective sheet 43 may include the multilayer structure and another member (e.g., an additional layer) stacked on the multilayer structure. The thickness and material of the protective sheet 43 are not particularly limited, as long as the sheet is a sheet of layered product suitable for protection of a surface of an electronic device and includes the multilayer structure described above.

The protective sheet 43 may, for example, include a surface protection layer placed on one or both of the surfaces of the multilayer structure. It is preferable for the surface protection layer to be a layer made of a scratch-resistant resin. A surface protection layer for a device such as a solar cell which may be used outdoors is preferably made of a resin having high weather resistance (e.g., light resistance). For protecting a surface required to permit transmission of light, a surface protection layer having high light transmittance is preferred. Examples of the material of the surface protection layer (surface protection film) include poly(meth)acrylic acid ester, polycarbonate, polyethylene terephthalate, polyethylene-2,6-naphthalate, polyvinyl fluoride (PVF), polyvinylidene fluoride (PVDF), polytetrafluoroethylene (PTFE), polychlorotrifluoroethylene (PCTFE), ethylene-tetrafluoroethylene copolymer (ETFE), ethylene-chlorotrifluoroethylene copolymer (ECTFE), tetrafluoroethylene-perfluoroalkyl vinyl ether copolymer (PFA), and tetrafluoroethylene-hexafluoropropylene copolymer (FEP). In an example, the protective sheet includes a poly(meth)acrylic acid ester layer placed on one of its surfaces.

An additive (e.g., an ultraviolet absorber) may be added to the surface protection layer to increase the durability of the surface protection layer. A preferred example of the surface protection layer having high weather resistance is an acrylic resin layer to which an ultraviolet absorber has been added. Examples of the ultraviolet absorber include, but are not limited to, ultraviolet absorbers based on benzotriazole, benzophenone, salicylate, cyanoacrylate, nickel, or triazine. In addition, another additive such as a stabilizer, light stabilizer, or antioxidant may be used in combination.

The present invention encompasses embodiments obtainable by combining the above features in various manners within the technical scope of the present invention as long as such embodiments exert the effect of the present invention.

### EXAMPLES

Hereinafter, the present invention will be described in more detail by way of examples. However, the present invention is not limited by these examples in any respect, and it should be understood that many modifications can be made by any ordinarily skilled person in the art within the technical concept of the present invention. Analysis and evaluation in Examples and Comparative Examples given below were performed as will now be described.

### (1) Infrared absorption spectrum of layer (Y)

The measurement was performed by attenuated total reflection spectroscopy using a Fourier transform infrared spectrophotometer. The measurement conditions were as follows.
Apparatus: Spectrum One, manufactured by PerkinElmer, Inc.
Measurement mode: Attenuated total reflection spectroscopy
Measurement range: 800 to 1,400 cm⁻¹

### (2) Measurement of respective thicknesses of layers

The multilayer structure was cut using a focused ion beam (FIB) to prepare a section (thickness: 0.3 µm) for cross-sectional observation. The prepared section was secured to a sample stage with a carbon tape and subjected to platinum ion sputtering at an accelerating voltage of 30 kV for 30 seconds. The cross-section of the multilayer structure was observed using a field-emission transmission electron microscope to determine the respective thicknesses of the layers. The measurement conditions were as follows.
Apparatus: JEM-2100F, manufactured by JEOL Ltd.
Accelerating voltage: 200 kV
Magnification: × 250,000

### (3) Quantification of metal ions

An amount of 5 mL of a high-purity nitric acid of analytical grade was put on 1.0 g of the multilayer structure, which was subjected to microwave decomposition. The resulting solution was adjusted in volume to 50 mL with ultrapure water to obtain a solution for quantitative analysis of metal ions other than aluminum ions. In addition, 0.5 mL of this solution was adjusted in volume to 50 mL with ultrapure water to obtain a solution for quantitative analysis of aluminum ions. The amounts of various metal ions contained in the solution obtained as above were determined by an internal reference method using an inductively coupled plasma emission spectrometer. The lower detection limit was 0.1 ppm for all of the metal ions. The measurement conditions were as follows.
Apparatus: Optima 4300DV, manufactured by PerkinElmer, Inc.
RF power: 1,300 W
Pump flow rate: 1.50 mL/min
Flow rate of auxiliary gas (argon): 0.20 L/min
Flow rate of carrier gas (argon): 0.70 L/min
Coolant gas: 15.0 L/min

### (4) Quantification of ammonium ions

The multilayer structure was cut into a piece with a size of 1 cm × 1 cm, which was frozen and crushed. The resulting powder was sieved with a sieve with a nominal size of 1 mm (complying with the normal sieve standards JIS Z 8801-1 to 3). An amount of 10 g of the powder fraction having passed through the sieve was dispersed in 50 mL of ion-exchanged water, and the dispersion was subjected to extraction operation at 95°C for 10 hours. The amount of ammonium ions contained in the resulting extract was determined using a cation chromatography apparatus. The lower detection limit was 0.02 ppb. The measurement conditions were as follows.
Apparatus: ICS-1600, manufactured by Dionex Corporation
Guard column: IonPAC CG-16 (5 mm Dia. × 50 mm), manufactured by Dionex Corporation
Separation column: IonPAC CS-16 (5 mm Dia. × 250 mm), manufactured by Dionex Corporation
Detector: Electrical conductivity detector
Eluent: 30 mmol/L aqueous methanesulfonic acid solution
Temperature: 40°C
Flow rate of eluent: 1 mL/min
Analyzed volume: 25 µL

### (5) Measurement of oxygen transmission rate

A sample was set to an oxygen transmission testing apparatus in such a manner that the layer as the base faced the carrier gas side, and the oxygen transmission rate was measured by an equal pressure method. The measurement conditions were as follows.
Apparatus: MOCON OX-TRAN 2/20, manufactured by ModernControls, Inc.
Temperature: 20°C
Humidity on oxygen feed side: 85% RH
Humidity on carrier gas side: 85% RH
Oxygen pressure: 1 atmosphere
Carrier gas pressure: 1 atmosphere

### (6) Measurement of water vapor transmission rate (equal pressure method)

A sample was set to a water vapor transmission testing apparatus in such a manner that the layer as the base faced the carrier gas side, and the moisture permeability (water vapor transmission rate) was measured by an equal pressure method. The measurement conditions were as follows.

Apparatus: MOCON PERMATRAN W3/33, manufactured by ModernControls, Inc.
Temperature: 40°C
Humidity on water vapor feed side: 90% RH
Humidity on carrier gas side: 0% RH

### (7) Measurement of water vapor transmission rate (differential pressure method) (Measurement of moisture permeability in Examples 1-36 to 1-39 and Comparative Example 1-7)

A sample was set to a water vapor transmission testing apparatus in such a manner that the layer as the base faced the water vapor feed side, and the moisture permeability (water vapor transmission rate) was measured by a differential pressure method. The measurement conditions were as follows.
Apparatus: Deltaperm, manufactured by Technolox Ltd.
Temperature: 40°C
Pressure on water vapor feed side (upper chamber): 50 Torr (6,665 Pa)
Pressure on water vapor transmission side (lower chamber): 0.003 Torr (0.4 Pa)

### <Synthesis example of polymer (G1-1)>

Under nitrogen atmosphere, 8.5 g of 2-phosphonooxyethyl methacrylate and 0.1 g of azobisisobutyronitrile were dissolved in 17 g of methyl ethyl ketone and the resulting solution was stirred at 80°C for 12 hours. The polymer solution obtained was cooled and then added to 170 g of 1,2-dichloroethane. This was followed by decantation to collect a polymer formed as a precipitate. Subsequently, the polymer was dissolved in tetrahydrofuran, and the solution was subjected to purification by reprecipitation using 1,2-dichloroethane as a poor solvent. The purification by reprecipitation was repeated three times, followed by vacuum drying at 50°C for 24 hours to obtain a polymer (G1-1). The polymer (G1-1) was a polymer of 2-phosphonooxyethyl methacrylate. As a result of GPC analysis, the number average molecular weight of the polymer was determined to be 10,000 on a polystyrene-equivalent basis.

### <Synthesis example of polymer (G1-2)>

Under nitrogen atmosphere, 10 g of vinylphosphonic acid and 0.025 g of 2,2'-azobis(2-amidinopropane) dihydrochloride were dissolved in 5 g of water, and the resulting solution was stirred at 80°C for 3 hours. After being cooled, the polymer solution was diluted by the addition of 15 g of water and then filtered using "Spectra/Por" (registered trademark), a cellulose membrane, manufactured by Spectrum Laboratories, Inc. Water was removed from the filtrate by distillation, followed by vacuum drying at 50°C for 24 hours to obtain a polymer (G1-2). The polymer (G1-2) was poly(vinylphosphonic acid). As a result of GPC analysis, the number average molecular weight of the polymer was determined to be 10,000 on a polyethylene glycol-equivalent basis.

### <Production example of first coating liquid (U-1)>

Distilled water in an amount of 230 parts by mass was heated to 70°C under stirring. Triisopropoxy aluminum in an amount of 88 parts by mass was added dropwise to the distilled water over 1 hour, the liquid temperature was gradually increased to 95°C, and isopropanol generated was distilled off. In this manner, hydrolytic condensation was performed. To the obtained liquid was added 4.0 parts by mass of a 60 mass% aqueous nitric acid solution, and this was followed by stirring at 95°C for 3 hours to deflocculate the agglomerates of the particles of the hydrolytic condensate. After that, 2.24 parts by mass of an aqueous sodium hydroxide solution with a concentration of 1.0 mol% was added to the liquid, which was then concentrated so that the solids concentration was adjusted to 10 mass% in terms of aluminum oxide. To 18.66 parts by mass of the thus obtained liquid were added 58.19 parts by mass of distilled water, 19.00 parts by mass of methanol, and 0.50 parts by mass of a 5 mass% aqueous polyvinyl alcohol solution (PVA 124, manufactured by KURARAY CO., LTD.; degree of saponification = 98.5 mol%, viscosity-average degree of polymerization = 2,400, viscosity of 4 mass% aqueous solution at 20°C = 60 mPa•s), and this was followed by stirring to achieve homogeneity. A dispersion as a metal oxide (A)-containing liquid was thus obtained. Subsequently, 3.66 parts by mass of an 85 mass% aqueous phosphoric acid solution as a phosphorus compound (B)-containing solution was added dropwise to the dispersion under stirring, with the liquid temperature held at 15°C. The stirring was continued further for 30 minutes after completion of the dropwise addition, thus yielding the intended first coating liquid (U-1) for which the values of N_{M}/N_{P}, F_{Z} × N_{Z}/N_{M}, and F_{Z} × N_{Z}/N_{P} were as shown in Table 1.

### <Production examples of first coating liquids (U-2) to (U-5)>

In the preparation of first coating liquids (U-2) to (U-5), the amount of the 1.0 mol% aqueous sodium hydroxide solution added for the preparation of a dispersion was changed so that the values of F_{Z} × N_{Z}/N_{M} and F_{Z} × N_{Z}/N_{P} were adjusted to those shown in Table 1 given below. Except for this difference, the first coating liquids (U-2) to (U-5) were prepared in the same manner as in the preparation of the first coating liquid (U-1).

### <Production example of first coating liquid (U-6)>

In the preparation of a first coating liquid (U-6), the aqueous sodium hydroxide solution was not added and the amount of the distilled water added was changed to 58.09 parts by mass for the preparation of a dispersion. Furthermore, the dropwise addition of the aqueous phosphoric acid solution to the dispersion was followed by addition of 0.10 parts by mass of a 1.0 mol% aqueous sodium hydroxide solution. Except for these differences, the first coating liquid (U-6) was prepared in the same manner as in the preparation of the first coating liquid (U-1).

### <Production example of first coating liquid (U-8)>

A first coating liquid (U-8) was prepared in the same manner as in the preparation of the first coating liquid (U-5), except for using trimethyl phosphate instead of phosphoric acid as the phosphorus compound (B) in the phosphorus compound (B)-containing solution.

### <Production example of first coating liquid (U-9)>

A first coating liquid (U-9) was prepared in the same manner as in the preparation of the first coating liquid (U-5), except for using a 5 mass% aqueous polyacrylic acid solution instead of the 5 mass% aqueous polyvinyl alcohol solution for the preparation of a dispersion.

### <Production examples of first coating liquids (U-7) and (U-10) to (U-18)>

First coating liquids (U-7) and (U-10) to (U-18) were prepared in the same manner as in the preparation of the first coating liquid (U-5), except for using aqueous solutions of various metal salts instead of the 1.0 mol% aqueous sodium hydroxide solution for the preparation of a dispersion. The aqueous metal salt solution used was a 1.0 mol% aqueous sodium chloride solution for the first coating liquid (U-7), a 1.0 mol% aqueous lithium hydroxide solution for the first coating liquid (U-10), a 1.0 mol% aqueous potassium hydroxide solution for the first coating liquid (U-11), a 0.5 mol% aqueous calcium chloride solution for the first coating liquid (U-12), a 0.5 mol% aqueous cobalt chloride solution for the first coating liquid (U-13), a 0.5 mol% aqueous zinc chloride solution for the first coating liquid (U-14), a 0.5 mol% aqueous magnesium chloride solution for the first coating liquid (U-15), a 1.0 mol% aqueous ammonia for the first coating liquid (U-16), an aqueous salt solution (a mixture of a 1.0 mol% aqueous sodium chloride solution and a 0.5 mol% aqueous calcium chloride solution) for the first coating liquid (U-17), and an aqueous salt solution (a mixture of a 0.5 mol% aqueous zinc chloride solution and a 0.5 mol% aqueous calcium chloride solution) for the first coating liquid (U-18).

### <Production examples of first coating liquids (U-19) to (U-23)>

First coating liquids (U-19) to (U-23) were prepared in the same manner as in the preparation of the first coating liquid (U-5), except for changing the ratios N_{M}/N_{P} and F_{Z} × N_{Z}/N_{P} in accordance with Table 1 given below.

### <Production examples of first coating liquids (U-34), (U-36), (U-37), (U-39), and (CU-5)>

The following were used instead of the aqueous sodium hydroxide solution for the preparation of a dispersion: 0.19 parts by mass of zinc oxide for a first coating liquid (U-34); 0.19 parts by mass of magnesium oxide for a first coating liquid (U-36); 0.38 parts by mass of boric acid for a first coating liquid (U-37); 0.30 parts by mass of calcium carbonate for a first coating liquid (U-39); and 0.38 parts by mass of tetraethoxysilane for a first coating liquid (CU-5). These were all added after the addition of the aqueous polyvinyl alcohol solution. Furthermore, the amount of distilled water added, which was 58.19 parts by mass in the preparation of the first coating liquid (U-1), was 58.00 parts by mass for the first coating liquid (U-34) and the first coating liquid (U-36), 57.89 parts by mass for the first coating liquid (U-39), and 57.81 parts by mass for the first coating liquid (U-37) and the first coating liquid (CU-5). Except for these changes, the first coating liquids (U-34), (U-36), (U-37), (U-39), and (CU-5) were prepared in the same manner as in the preparation of the first coating liquid (U-1).

### <Production examples of first coating liquids (U-40) and (U-41)>

In the preparation of first coating liquids (U-40) and (U-41), a 1.0 mol% aqueous sodium hydroxide solution and a 1.0 mol% aqueous potassium hydroxide solution were added for the preparation of a dispersion so that the values of F_{Z} × N_{Z}/N_{M} and F_{Z} × N_{Z}/N_{P} were adjusted to those shown in Table 1 given below. Except for this difference, the first coating liquids (U-40) and (U-41) were prepared in the same manner as in the preparation of the first coating liquid (U-1).

### <Production examples of first coating liquids (U-42) to (U-44)>

The following were used instead of the aqueous sodium hydroxide solution for the preparation of a dispersion: 0.015 parts by mass of lanthanum oxide for a first coating liquid (U-42); 0.006 parts by mass of boric acid for a first coating liquid (U-43); and 0.007 parts by mass of zinc oxide for a first coating liquid (U-44). These were all added after the addition of the aqueous polyvinyl alcohol solution. The amount of distilled water added, which was 58.19 parts by mass in the preparation of the first coating liquid (U-1), was 58.17 parts by mass for the first coating liquid (U-42) and 58.18 parts by mass for the first coating liquids (U-43) and (U-44). Except for these changes, the first coating liquids (U-42) to (U-44) were prepared in the same manner as in the preparation of the first coating liquid (U-1).

### <Production examples of first coating liquids (U-45) and (U-46)>

In the preparation of first coating liquids (U-45) and (U-46), the 5 mass% aqueous polyvinyl alcohol solution was not added for the preparation of a dispersion. Furthermore, the amount of distilled water added was changed to 58.57 parts by mass for the first coating liquids (U-45) and (U-46). Except for these differences, the first coating liquids (U-45) and (U-46) were prepared in the same manner as in the preparation of the first coating liquids (U-40) and (U-41).

### <Production examples of first coating liquids (U-47) to (U-49)>

In the preparation of first coating liquids (U-47) to (U-49), the 5 mass% aqueous polyvinyl alcohol solution was not added for the preparation of a dispersion. Furthermore, the amount of distilled water added was 58.56 parts by mass for the first coating liquid (U-47) and 58.57 parts by mass for the first coating liquids (U-48) and (U-49). Except for these changes, the first coating liquids (U-47) to (U-49) were prepared in the same manner as in the preparation of the first coating liquids (U-42) to (U-44).

### <Production example of first coating liquid (CU-1)>

A first coating liquid (CU-1) was prepared in the same manner as in the preparation of the first coating liquid (U-1), except that the 1.0 mol% aqueous sodium hydroxide solution was not added for the preparation of a dispersion.

### <Production examples of first coating liquids (CU-2) and (CU-6)>

First coating liquids (CU-2) and (CU-6) were prepared in the same manner as in the preparation of the first coating liquid (U-1), except for changing the amount of the 1.0 mol% aqueous sodium hydroxide solution added for the preparation of a dispersion so that the values of F_{Z} × N_{Z}/N_{M} were adjusted to those shown in Table 1.

### <Production example of first coating liquid (CU-8)>

A first coating liquid (CU-8) was prepared in the same manner as in the preparation of the first coating liquid (U-1), except that the 5 mass% aqueous polyvinyl alcohol solution was not added and the amount of distilled water added was changed to 58.57 parts by mass for the preparation of a dispersion.

### <Production examples of first coating liquids (CU-3) and (CU-4)>

First coating liquids (CU-3) and (CU-4) were prepared in the same manner as in the preparation of the first coating liquid (U-5), except that the values of N_{M}/N_{P} were adjusted in accordance with Table 1.

### <Production examples of second coating liquids (V-1) to (V-6)>

First, the polymer (G1-1) as obtained in the synthesis example was dissolved in a mixed solvent of water and methanol (mass ratio of water : methanol = 7 : 3) to obtain a second coating liquid (V-1) with a solids concentration of 1 mass%. There was also prepared a mixture containing 91 mass% of the polymer (G1-1) as obtained in the synthesis example and 9 mass% of polyvinyl alcohol (PVA 124, manufactured by KURARAY CO., LTD.; degree of saponification = 98.5 mol%, viscosity-average degree of polymerization = 2,400, viscosity of 4 mass% aqueous solution at 20°C = 60 mPa•s). This mixture was dissolved in a mixed solvent of water and methanol (mass ratio of water : methanol = 7 : 3) to obtain a second coating liquid (V-2) with a solids concentration of 1 mass%. Furthermore, there was prepared a mixture containing 91 mass% of the polymer (G1-1) as obtained in the synthesis example and 9 mass% of polyacrylic acid (number average molecular weight = 210,000, weight average molecular weight = 1,290,000). This mixture was dissolved in a mixed solvent of water and methanol (mass ratio of water : methanol = 7 : 3) to obtain a second coating liquid (V-3) with a solids concentration of 1 mass%. In addition, second coating liquids (V-4) to (V-6) were obtained in the same manner as in the preparation of the second coating liquids (V-1) to (V-3), except for replacing the polymer (G1-1) by the polymer (G1-2).

The details of films used in Examples and Comparative Examples were as follows.
1) PET 12: Oriented polyethylene terephthalate film; "Lumirror P60" (trade name), manufactured by TORAY INDUSTRIES, INC. and having a thickness of 12 µm)
2) PET 125: Oriented polyethylene terephthalate film; "Lumirror S10" (trade name), manufactured by TORAY INDUSTRIES, INC. and having a thickness of 125 µm)
3) PET 50: Polyethylene terephthalate film with improved adhesion to ethylene-vinyl acetate copolymer; "SHINEBEAM Q1A15" (trade name), manufactured by TOYOBO CO., LTD. and having a thickness of 50 µm)
4) ONY: Oriented nylon film; "EMBLEM ONBC" (trade name), manufactured by UNITIKA LTD. and having a thickness of 15 µm)
5) CPP 50: Non-oriented polypropylene film; "RXC-21" (trade name), manufactured by Mitsui Chemicals Tohcello, Inc. and having a thickness of 50 µm)
6) CPP 60: Non-oriented polypropylene film; "RXC-21" (trade name), manufactured by Mitsui Chemicals Tohcello, Inc. and having a thickness of 60 µm)
7) CPP 70: Non-oriented polypropylene film; "RXC-21" (trade name), manufactured by Mitsui Chemicals Tohcello, Inc. and having a thickness of 70 µm)
8) CPP 100: Non-oriented polypropylene film; "RXC-21" (trade name), manufactured by Mitsui Chemicals Tohcello, Inc. and having a thickness of 100 µm)

### [Example 1] <Example 1-1>

First, a PET 12 was prepared as the base (X). The first coating liquid (U-1) was applied onto this base using a bar coater in such a manner that the dry thickness would be 0.5 µm. The applied film was dried at 100°C for 5 minutes to form a precursor layer of the layer (Y) on the base. This was followed by heat treatment at 180°C for 1 minute to form the layer (Y). In this way, a multilayer structure (1-1) having a configuration of "layer (Y) (0.5 µm)/PET" was obtained.

As a result of measurement of the infrared absorption spectrum of the multilayer structure (1-1), the maximum absorption wavenumber in the region of 800 to 1,400 cm⁻¹ was determined to be 1,107 cm⁻¹, and the half width of the maximum absorption band in the same region was determined to be 37 cm⁻¹. The result is shown in Table 1.

As a result of quantitative analysis of sodium ions contained in the multilayer structure (1-1), the value of {(ionic charge of sodium ions) x (number of moles of sodium ions)}/(number of moles of aluminum ions) was determined to be 0.005. The result is shown in Table 1.

A sample with a size of 21 cm × 30 cm was cut from the multilayer structure (1-1), and this sample was allowed to stand still at 23°C and 50% RH for 24 hours, after which, under the same conditions, the sample was longitudinally stretched by 5% and allowed to keep the stretched state for 10 seconds. The multilayer structure (1-1) subjected to a stretching process was thus prepared. The oxygen transmission rate and moisture permeability of the multilayer structure (1-1) were measured before and after the stretching process. The results are shown in Table 2.

### <Examples 1-2 to 1-23>

Multilayer structures (1-2) to (1-23) of Examples 1-2 to 1-23 were fabricated in the same manner as in the fabrication of the multilayer structure (1-1) of Example 1, except for using the first coating liquids (U-2) to (U-23) instead of the first coating liquid (U-1). As a result of analysis of the metal ion content in the multilayer structure (1-4) of Example 1-4, the value of {(ionic charge of sodium ions) × (number of moles of sodium ions)}/(number of moles of aluminum ions) was determined to be 0.240.

### <Example 1-24>

The first coating liquid (U-4) was applied onto a PET 12 using a bar coater in such a manner that the dry thickness would be 0.5 µm, and the applied film was dried at 110°C for 5 minutes to form a precursor layer of the layer (Y) on the base. The resulting layered product was subsequently heat-treated at 160°C for 1 minute to form the layer (Y). In this way, a multilayer structure having a configuration of "layer (Y) (0.5 µm)/PET" was obtained. The second coating liquid (V-1) was applied onto the layer (Y) of the multilayer structure using a bar coater in such a manner that the dry thickness would be 0.3 µm, and was dried at 200°C for 1 minute to form the layer (W). In this way, a multilayer structure (1-24) of Example 1-24 having a configuration of "layer (W) (0.3 µm)/layer (Y) (0.5 µm)/PET" was obtained.

### <Examples 1-25 to 1-29>

Multilayer structures (1-25) to (1-29) of Example 1-25 to 1-29 were obtained in the same manner as in the fabrication of the multilayer structure (1-24) of Example 1-24, except for using the second coating liquids (V-2) to (V-6) instead of the second coating liquid (V-1).

### <Example 1-30>

A deposited layer (X') of aluminum oxide with a thickness of 0.03 µm was formed on a PET 12 by vacuum deposition. The first coating liquid (U-4) was applied onto this deposited layer using a bar coater in such a manner that the dry thickness would be 0.5 µm, and the applied film was dried at 110°C for 5 minutes to form a precursor layer of the layer (Y) on the base. The resulting layered product was subsequently heat-treated at 180°C for 1 minute to form the layer (Y). In this way, a multilayer structure (1-30) having a configuration of "layer (Y) (0.5 µm)/deposited layer (X') (0.03 µm)/PET" was obtained.

### <Example 1-31>

A deposited layer (X') of aluminum oxide with a thickness of 0.03 µm was formed by vacuum deposition on the layer (Y) of the multilayer structure (1-4) as obtained in Example 1-4, and thus a multilayer structure (1-31) having a configuration of "deposited layer (X') (0.03 µm)/layer (Y) (0.5 µm)/PET" was obtained.

### <Example 1-32>

Deposited layers (X') of aluminum oxide with a thickness of 0.03 µm were formed on both surfaces of a PET 12 by vacuum deposition. The first coating liquid (U-4) was applied onto both of the deposited layers using a bar coater in such a manner that the dry thickness would be 0.5 µm, and the applied films were dried at 110°C for 5 minutes to form precursor layers of the layers (Y). The resulting layered product was subsequently heat-treated using a dryer at 180°C for 1 minute to form the layers (Y). In this way, a multilayer structure (1-32) having a configuration of "layer (Y) (0.5 µm)/deposited layer (X') (0.03 µm)/PET/deposited layer (X') (0.03 µm)/layer (Y) (0.5 µm)" was obtained.

### <Example 1-33>

The first coating liquid (U-4) was applied onto both surfaces of a PET 12 using a bar coater in such a manner that the dry thickness would be 0.5 µm on each surface, and the applied films were dried at 110°C for 5 minutes to form precursor layers of the layers (Y) on the base. The resulting layered product was subsequently heat-treated using a dryer at 180°C for 1 minute to form the layers (Y). Deposited layers (X') of aluminum oxide with a thickness of 0.03 µm were formed on the two layers (Y) of the layered product by vacuum deposition. In this way, a multilayer structure (1-33) having a configuration of "deposited layer (X') (0.03 µm)/layer (Y) (0.5 µm)/PET/layer (Y) (0.5 µm)/deposited layer (X') (0.03 µm)" was obtained.

### <Example 1-34>

A multilayer structure (1-34) of Example 1-34 was obtained in the same manner as in the fabrication of the multilayer structure (1-1) of Example 1-1, except for using the first coating liquid (U-34) instead of the first coating liquid (U-1).

### <Example 1-35>

A multilayer structure (1-35) of Example 1-35 was obtained in the same manner as in the fabrication of the multilayer structure (1-24) of Example 1-24, except for using the first coating liquid (U-34) instead of the first coating liquid (U-1) and the second coating liquid (V-4) instead of the second coating liquid (V-1).

### <Example 1-36>

The first coating liquid (U-36) was applied onto a PET 125 using a bar coater in such a manner that the dry thickness would be 0.3 µm, and was then dried at 110°C for 5 minutes. The drying was followed by heat treatment at 180°C for 1 minute. In this way, a multilayer structure (1-36) was obtained.

### <Examples 1-37 to 1-39>

Multilayer structures (1-37) to (1-39) of Examples 1-37 to 1-39 were obtained in the same manner as in the fabrication of the multilayer structure (1-36) of Example 1-36, except for using the first coating liquids (U-37), (U-34), and (U-39) instead of the first coating liquid (U-36).

### <Comparative Examples 1-1 to 1-6>

Multilayer structures (C1-1) to (C1-6) of Comparative Examples 1-1 to 1-6 were fabricated in the same manner as in the fabrication of the multilayer structure (1-1) of Example 1-1, except for using the first coating liquids (CU-1) to (CU-6) instead of the first coating liquid (U-1). As a result of analysis of the metal ion content in the multilayer structure (C1-1) of Comparative Example 1-1, the content was determined to be less than the lower detection limit, which means that the value of {(ionic charge of sodium ions) × (number of moles of sodium ions)}/(number of moles of aluminum ions) was less than 0.001.

### <Comparative Example 1-7>

A multilayer structure (C1-7) of Comparative Example 1-7 was fabricated in the same manner as in the fabrication of the multilayer structure (1-36) of Example 1-36, except for using the first coating liquid (CU-7) instead of the first coating liquid (U-36).

The conditions of formation of the layers (Y) in Examples 1-1 to 1-39, the layers (CY) in Comparative Examples 1-1 to 1-7 which are to be compared with the layers (Y), and the layers (W), are shown in Table 1. The abbreviations in Table 1 refer to the following materials.
PVA: Polyvinyl alcohol (PVA 124, manufactured by KURARAY CO., LTD.)
PAA: Polyacrylic acid (Aron-15H, manufactured by TOAGOSEI CO., LTD.)
PPEM: Poly(2-phosphonooxyethyl methacrylate)
PVPA: Poly(vinylphosphonic acid)

**[Table 1]**

| | Base (X) | Layer (Y) | | | | | | | Layer (W) | | | Maximum absorption wavenumber (cm-1) |
|---|---|---|---|---|---|---|---|---|---|---|---|---|
| | | Coating liquid (U) No. | Cations (Z) | Phosphorus compound(B) | Polymer (C) | F_{Z} × N_{Z}/N_{M} | N_{M}/N_{P} | F_{Z} × N_{Z}/N_{P} | Coating liquid (V) No. | Polymer (G1) | Polymer (G2) | |
| Example 1-1 | PET 12 | U-1 | Na⁺ | Phosphoric acid | PVA | 0.005 | 1.15 | 0.0058 | - | - | - | 1,107 |
| Example 1-2 | PET 12 | U-2 | Na^{*} | Phosphoric acid | PVA | 0.280 | 1.15 | 0.3220 | - | - | - | 1,107 |
| Example 1-3 | PET 12 | U-3 | Na⁺ | Phosphoric acid | PVA | 0.050 | 1.15 | 0.0575 | - | - | - | 1,108 |
| Example 1-4 | PET 12 | U-4 | Na⁺ | Phosphoric acid | PVA | 0.240 | 1.15 | 0.2760 | - | - | - | 1,107 |
| Example 1-5 | PET 12 | U-5 | Na⁺ | Phosphoric acid | PVA | 0.200 | 1.15 | 0.2300 | - | - | - | 1,108 |
| Example 1-6 | PET 12 | U-6 | Na⁺ | Phosphoric acid | PVA | 0.200 | 1.15 | 0.2300 | - | - | - | 1.107 |
| Example 1-7 | PET 12 | U-7 | Na⁺ | Phosphoric acid | PVA | 0.200 | 1.15 | 0.2300 | - | - | - | 1.107 |
| Example 1-8 | PET 12 | U-8 | Na⁺ | Trimethyl phosphate | PVA | 0.200 | 1.15 | 0.2300 | - | - | - | 1.107 |
| Example 1-9 | PET 12 | U-9 | Na⁺ | Phosphoric acid | PAA | 0.200 | 1.15 | 0.2300 | - | - | - | 1.107 |
| Example 1-10 | PET 12 | U-10 | Li⁺ | Phosphoric acid | PVA | 0.200 | 1.15 | 0.2300 | - | - | - | 1,108 |
| Example 1-11 | PET 12 | U-11 | K⁺ | Phosphoric acid | PVA | 0.200 | 1.15 | 0.2300 | - | - | - | 1,108 |
| Example 1-12 | PET 12 | U-12 | Ca²⁺ | Phosphoric acid | PVA | 0.200 | 1.15 | 0.2300 | - | - | - | 1,108 |
| Example 1-13 | PET 12 | U-13 | Co²⁺ | Phosphoric acid | PVA | 0.200 | 1.15 | 0.2300 | - | - | - | 1,107 |
| Example 1-14 | PET 12 | U-14 | Zn²⁺ | Phosphoric acid | PVA | 0.200 | 1.15 | 0.2300 | - | - | - | 1,108 |
| Example 1-15 | PET 12 | U-15 | Mg²⁺ | Phosphoric acid | PVA | 0.200 | 1.15 | 0.2300 | - | - | - | 1,108 |
| Example 1-16 | PET 12 | U-16 | NH⁴⁺ | Phosphoric acid | PVA | 0.200 | 1.15 | 0.2300 | - | - | - | 1,108 |
| Example 1-17 | PET 12 | U-17 | Na⁺, Ca²⁺ | Phosphoric acid | PVA | 0.200 | 1.15 | 0.2300 | - | - | - | 1.107 |
| Example 1-18 | PET 12 | U-18 | Ca²⁺, Zn²⁺ | Phosphoric acid | PVA | 0.200 | 1.15 | 0.2300 | - | - | - | 1,108 |
| Example 1-19 | PET 12 | U-19 | Na⁺ | Phosphoric acid | PVA | 0.200 | 2.60 | 0.5200 | - | - | - | 1,111 |
| Example 1-20 | PET 12 | U-20 | Na⁺ | Phosphoric acid | PVA | 0.200 | 1.06 | 0.2120 | - | - | - | 1.110 |
| Example 1-21 | PET 12 | U-21 | Na⁺ | Phosphoric acid | PVA | 0.200 | 3.07 | 0.6140 | - | - | - | 1,113 |
| Example 1-22 | PET 12 | U-22 | Na⁺ | Phosphoric acid | PVA | 0.200 | 0.88 | 0.1760 | - | - | - | 1,107 |
| Example 1-23 | PET 12 | U-23 | Na⁺ | Phosphoric acid | PVA | 0.200 | 3.99 | 0.7980 | - | - | - | 1,118 |
| Example 1-24 | PET 12 | U-4 | Na⁺ | Phosphoric acid | PVA | 0.240 | 1.15 | 0.2760 | V-1 | PPEM | - | 1,107 |
| Example 1-25 | PET 12 | U-4 | Na⁺ | Phosphoric acid | PVA | 0.240 | 1.15 | 0.2760 | V-2 | PPEM | PVA | 1,107 |
| Example 1-26 | PET 12 | U-4 | Na⁺ | Phosphoric acid | PVA | 0.240 | 1.15 | 0.2760 | V-3 | PPEM | PAA | 1,107 |
| Example 1-27 | PET 12 | U-4 | Na^{*} | Phosphoric acid | PVA | 0.240 | 1.15 | 0.2760 | V-4 | PVPA | - | 1,107 |
| Example 1-28 | PET 12 | U-4 | Na⁺ | Phosphoric acid | PVA | 0.240 | 1.15 | 0.2760 | V-5 | PVPA | PVA | 1,107 |
| Example 1-29 | PET 12 | U-4 | Na⁺ | Phosphoric acid | PVA | 0.240 | 1.15 | 0.2760 | V-6 | PVPA | PAA | 1,107 |
| Example 1-30 | PET 12 | U-4 | Na⁺ | Phosphoric acid | PVA | 0.240 | 1.15 | 0.2760 | - | - | - | 1,107 |
| Example 1-31 | PET 12 | U-4 | Na⁺ | Phosphoric acid | PVA | 0.240 | 1.15 | 0.2760 | - | - | - | 1,107 |
| Example 1-32 | PET 12 | U-4 | Na⁺ | Phosphoric acid | PVA | 0.240 | 1.15 | 0.2760 | - | - | - | 1,107 |
| Example 1-33 | PET 12 | U-4 | Na⁺ | Phosphoric acid | PVA | 0.240 | 1.15 | 0.2760 | - | - | - | 1,107 |
| Example 1-34 | PET 12 | U-34 | Zn²⁺ | Phosphoric acid | PVA | 0.10 | 1.15 | 0.1150 | - | - | - | 1,107 |
| Example 1-35 | PET 12 | U-34 | Zn²⁺ | Phosphoric acid | PVA | 0.10 | 1.15 | 0.1150 | V-4 | PVPA | - | 1,107 |
| Example 1-36 | PET 125 | U-36 | Mg²⁺ | Phosphoric acid | PVA | 0.26 | 1.15 | 0.2990 | - | - | - | 1,107 |
| Example 1-37 | PET 125 | U-37 | B³⁺ | Phosphoric acid | PVA | 0.50 | 1.15 | 0.5750 | - | - | - | 1,107 |
| Example 1-38 | PET 125 | U-34 | Zn²⁺ | Phosphoric acid | PVA | 0.10 | 1.15 | 0.1150 | - | - | - | 1.107 |
| Example 1-39 | PET 125 | U-39 | Ca²⁺ | Phosphoric acid | PVA | 0.10 | 1.15 | 0.1150 | - | - | - | 1,107 |
| Comp. Example 1-1 | PET 12 | CU-1 | - | Phosphoric acid | PVA | - | 1.15 | - | - | - | - | 1,107 |
| Comp. Example 1-2 | PET 12 | CU-2 | Na⁺ | Phosphoric acid | PVA | 0.0005 | 1.15 | 0.0006 | - | - | - | 1,108 |
| Comp. Example 1-3 | PET 12 | CU-3 | Na⁺ | Phosphoric acid | PVA | 0.200 | 0.34 | 0.0680 | - | - | - | 1,136 |
| Comp. Example 1-4 | PET 12 | CU-4 | Na⁺ | Phosphoric acid | PVA | 0.200 | 5.77 | 1.1540 | - | - | - | 1,145 |
| Comp. Example 1-5 | PET 12 | CU-5 | Si⁴⁺ | Phosphoric acid | PVA | 0.200 | 1.15 | 0.2300 | - | - | - | 1,107 |
| Comp. Example 1-6 | PET 12 | CU-6 | Na⁺ | Phosphoric acid | PVA | 0.620 | 1.15 | 0.7130 | - | - | - | 1,107 |
| Comp. Example 1-7 | PET 12 | CU-1 | - | Phosphoric acid | PVA | - | 1.15 | | - | - | - | 1,107 |

The multilayer structures of Examples 1-2 to 1-39 and Comparative Examples 1-1 to 1-7 were evaluated in the same manner as the multilayer structure (1-1) of Example 1-1. The configurations of the multilayer structures of Examples and Comparative Examples and the evaluation results are shown in Table 2. In Table 2, "-" indicates that the measurement was not done.

**[Table 2]**

| | Multilayer structure | | Oxygen transmission rate mL/(m² • day• atm) | | Moisture permeability g/(m² day) | |
|---|---|---|---|---|---|---|
| | No. | Configuration | Before stretching | After stretching | Before stretching | After stretching |
| Example 1-1 | 1-1 | (X)/(Y) | 0.4 | 1.1 | 0.2 | 1.6 |
| Example 1-2 | 1-2 | (X)/(Y) | 0.7 | 1.0 | 0.5 | 1.5 |
| Example 1-3 | 1-3 | (X)/(Y) | 0.3 | 0.9 | 0.2 | 1.3 |
| Example 1-4 | 1-4 | (X)/(Y) | 0.4 | 0.6 | 0.2 | 0.8 |
| Example 1-5 | 1-5 | (X)/(Y) | 0.4 | 0.8 | 0.3 | 1.0 |
| Example 1-6 | 1-6 | (X)/(Y) | 0.4 | 1.2 | 0.3 | 1.5 |
| Example 1-7 | 1-7 | (X)/(Y) | 0.4 | 1.1 | 0.3 | 1.6 |
| Example 1-8 | 1-8 | (X)/(Y) | 0.5 | 1.0 | 0.3 | 1.4 |
| Example 1-9 | 1-9 | (X)/(Y) | 0.4 | 0.9 | 0.3 | 1.3 |
| Example 1-10 | 1-10 | (X)/(Y) | 0.4 | 1.0 | 0.3 | 1.3 |
| Example 1-11 | 1-11 | (X)/(Y) | 0.4 | 0.8 | 0.3 | 0.9 |
| Example 1-12 | 1-12 | (X)/(Y) | 0.4 | 0.9 | 0.3 | 1.3 |
| Example 1-13 | 1-13 | (X)/(Y) | 0.5 | 1.0 | 0.4 | 1.4 |
| Example 1-14 | 1-14 | (X)/(Y) | 0.4 | 1.0 | 0.3 | 1.3 |
| Example 1-15 | 1-15 | (X)/(Y) | 0.4 | 0.9 | 0.3 | 1.4 |
| Example 1-16 | 1-16 | (X)/(Y) | 0.4 | 0.8 | 0.3 | 1.5 |
| Example 1-17 | 1-17 | (X)/(Y) | 0.4 | 0.7 | 0.3 | 1.0 |
| Example 1-18 | 1-18 | (X)/(Y) | 0.4 | 0.8 | 0.3 | 1.0 |
| Example 1-19 | 1-19 | (X)/(Y) | 0.7 | 1.1 | 0.8 | 1.4 |
| Example 1-20 | 1-20 | (X)/(Y) | 0.9 | 1.3 | 1.0 | 1.8 |
| Example 1-21 | 1-21 | (X)/(Y) | 0.9 | 1.2 | 1.1 | 1.5 |
| Example 1-22 | 1-22 | (X)/(Y) | 1.0 | 1.4 | 1.2 | 2.0 |
| Example 1-23 | 1-23 | (X)/(Y) | 1.1 | 1.6 | 1.2 | 1.9 |
| Example 1-24 | 1-24 | (X)/(Y)/(W) | 0.4 | 0.5 | 0.2 | 0.5 |
| Example 1-25 | 1-25 | (X)/(Y)/(W) | 0.4 | 0.5 | 0.2 | 0.6 |
| Example 1-26 | 1-26 | (X)/(Y)/(W) | 0.4 | 0.5 | 0.2 | 0.7 |
| Example 1-27 | 1-27 | (X)/(Y)/(W) | 0.4 | 0.5 | 0.2 | 0.4 |
| Example 1-28 | 1-28 | (X)/(Y)/(W) | 0.4 | 0.5 | 0.2 | 0.5 |
| Example 1-29 | 1-29 | (X)/(Y)/(W) | 0.4 | 0.5 | 0.2 | 0.7 |
| Example 1-30 | 1-30 | (X)/(X')/(Y) | < 0.1 | 0.3 | < 0.1 | 0.2 |
| Example 1-31 | 1-31 | (X)/(Y)/(X') | < 0.1 | 0.4 | < 0.1 | 0.3 |
| Example 1-32 | 1-32 | (Y)/(X')/(X)/(X')/(Y) | < 0.1 | 0.1 | < 0.1 | 0.1 |
| Example 1-33 | 1-33 | (X')/(Y)/(X)/(Y)/(X') | < 0.1 | 0.2 | < 0.1 | 0.1 |
| Example 1-34 | 1-34 | (X)/(Y) | 0.3 | 0.8 | 0.2 | 1.1 |
| Example 1-35 | 1-35 | (X)/(Y)/(W) | 0.3 | 0.5 | 0.2 | 0.7 |
| Example 1-36 | 1-36 | (X)/(Y) | - | - | 4.5 × 10⁻³ | - |
| Example 1-37 | 1-37 | (X)/(Y) | - | - | 4.4 × 10-3 | - |
| Example 1-38 | 1-38 | (X)/(Y) | - | - | 8.1 × 10⁻³ | - |
| Example 1-39 | 1-39 | (X)/(Y) | - | - | 5.1 × 10⁻³ | - |
| Comp. Example 1-1 | C1-1 | (X)/(CY) | 0.2 | 6.1 | 0.2 | 7.2 |
| Comp. Example 1-2 | C1-2 | (X)/(CY) | 0.2 | 6.0 | 0.2 | 7.0 |
| Comp. Example 1-3 | C1-3 | (X)/(CY) | 5.6 | 8.6 | > 50 | > 50 |
| Comp. Example 1-4 | C1-4 | (X)/(CY) | 4.2 | 9.8 | > 50 | > 50 |
| Comp. Example 1-5 | C1-5 | (X)/(CY) | 0.4 | 6.0 | 0.2 | 7.8 |
| Comp. Example 1-6 | C1-6 | (X)/(CY) | 1.8 | 3.2 | 5.3 | 6.2 |
| Comp. Example 1-7 | C1-7 | (X)/(CY) | - | - | 1.0 × 10⁻² | - |

As is apparent from Table 2, the multilayer structures of Examples successfully maintained both the gas barrier properties and water vapor barrier properties at high levels even when exposed to a high physical stress. The multilayer structures including the layer (W) in addition to the layer (Y) were superior in barrier properties measured after stretching to the multilayer structures including only the layer (Y). The multilayer structure including the layer (W) or the inorganic deposited layer (X') in addition to the layer (Y) was superior in barrier properties measured after stretching to the multilayer structures including only the layer (Y).

### <Examples 1-40 to 1-49>

Multilayer structures (1-40) to (1-49) of Examples 1-40 to 1-49 were obtained in the same manner as in the fabrication of the multilayer structure (1-1) of Example 1-1, except for using the first coating liquids (U-40) to (U-49) instead of the first coating liquid (U-1).

### <Comparative Example 1-8>

A multilayer structure (C1-8) of Comparative Example 1-8 was fabricated in the same manner as in the fabrication of the multilayer structure (1-1) of Example 1, except for using the first coating liquid (CU-8) instead of the first coating liquid (U-1).

The conditions of formation of the layers (Y) in Examples 1-40 to 1-49 and the layers (CY) of Comparative Examples 1-1 and 1-8 which are to be compared with the layers (Y) are shown in Table 3. The abbreviation in Table 3 refers to the following material.
PVA: Polyvinyl alcohol (PVA 124, manufactured by KURARAY CO., LTD.)

**[Table 3]**

| | Base (X) | Layer (Y) | | | | | | | Maximum absorption wavenumber (cm⁻¹) |
|---|---|---|---|---|---|---|---|---|---|
| | | Coating liquid (U) No. | Cations (Z) | Phosphorus compound (B) | Polymer (C) | F_{Z} × N_{Z}/N_{M} | N_{M}/N_{P} | F_{Z} × N_{Z}/N_{P} | |
| Example 1-40 | PET 12 | U-40 | Na⁺ | Phosphoric acid | PVA | 0.01 | 1.15 | 0.0115 | 1,107 |
| Example 1-41 | PET 12 | U-41 | K⁺ | Phosphoric acid | PVA | 0.01 | 1.15 | 0.0115 | 1,107 |
| Example 1-42 | PET 12 | U-42 | La³⁺ | Phosphoric acid | PVA | 0.03 | 1.15 | 0.0345 | 1,107 |
| Example 1-43 | PET 12 | U-43 | B³⁺ | Phosphoric acid | PVA | 0.03 | 1.15 | 0.0345 | 1,107 |
| Example 1-44 | PET 12 | U-44 | Zn²⁺ | Phosphoric acid | PVA | 0.02 | 1.15 | 0.0230 | 1,107 |
| Example 1-45 | PET 12 | U-45 | Na⁺ | Phosphoric acid | - | 0.01 | 1.15 | 0.0115 | 1,107 |
| Example 1-46 | PET 12 | U-46 | K⁺ | Phosphoric acid | - | 0.01 | 1.15 | 0.0115 | 1,107 |
| Example 1-47 | PET 12 | U-47 | La³⁺ | Phosphoric acid | - | 0.03 | 1.15 | 0.0345 | 1,107 |
| Example 1-48 | PET 12 | U-48 | B³⁺ | Phosphoric acid | - | 0.03 | 1.15 | 0.0345 | 1,107 |
| Example 1-49 | PET 12 | U-49 | Zn²⁺ | Phosphoric acid | - | 0.02 | 1.15 | 0.0230 | 1,107 |
| Comp. Example 1-1 | PET 12 | CU-1 | - | Phosphoric acid | PVA | - | 1.15 | - | 1.107 |
| Comp. Example 1-8 | PET 12 | CU-8 | - | Phosphoric acid | - | - | 1.15 | - | 1,107 |

An adhesive layer was formed on each of the multilayer structures (1-40) to (1-49), (C1-1), and (C1-8) as obtained in Examples 1-40 to 1-49 and Comparative Examples 1-1 and 1-8, and an ONY was then laminated on the adhesive layer. Layered products were thus obtained. Next, an adhesive layer was formed on the ONY of each layered product, and a CPP 50 was then laminated on the adhesive layer. The resulting layered product was allowed to stand still at 40°C for 5 days for aging. In this way, multilayer structures (1-40-2) to (1-49-2), (C1-1-2), and (C1-8-2) having a configuration of "base (X)/layer (Y)/adhesive layer/ONY/adhesive layer/CPP" were obtained. Each of the two adhesive layers was formed by applying a two-component adhesive using a bar coater in such a manner that the dry thickness would be 3 µm and then drying the adhesive. The two-component adhesive used was a two-component reactive polyurethane adhesive composed of "TAKELAC A-520" (trade name) manufactured by Mitsui Chemicals, Inc. and "TAKENATE A-50" (trade name) manufactured by Mitsui Chemicals, Inc. The oxygen transmission rate was measured for the multilayer structures (1-40-2) to (1-49-2), (C1-1-2), and (C1-8-2). The results are shown in Table 4.

Each of the multilayer structures (1-40-2) to (1-49-2), (C1-1-2), and (C1-8-2) was cut into pieces with dimensions of 120 mm × 120 mm. The two pieces of each multilayer structure were stacked together in such a manner that the CPPs were located interiorly, and the rectangular stack were heat-sealed at its three sides to form a flat pouch. The pouch was filled with 100 g of water. The pouch thus obtained was then subjected to retorting (hot water retaining method) under the following conditions.
Retorting apparatus: Flavor Ace RSC-60, manufactured by HISAKA WORKS, LTD.
Temperature: 130°C
Time: 30 minutes
Pressure: 0.21 MPaG

Immediately after the retorting, a measurement sample was cut out from the pouch, and the oxygen transmission rate was measured for the sample by the method described above. The results are shown in Table 4.

**[Table 4]**

| | Multilayer structure | | Oxygen transmission rate mL/(m² • day • atm) | |
|---|---|---|---|---|
| | No. | Configuration | Before retorting | After retorting |
| Example 1-40 | 1-40-2 | (X)/(Y) | 0.3 | 2.2 |
| Example 1-41 | 1-41-2 | (X)/(Y) | 0.3 | 2.0 |
| Example 1-42 | 1-42-2 | (X)/(Y) | 0.4 | 0.9 |
| Example 1-43 | 1-43-2 | (X)/(Y) | 0.2 | 0.5 |
| Example 1-44 | 1-44-2 | (X)/(Y) | 0.2 | 0.4 |
| Example 1-45 | 1-45-2 | (X)/(Y) | 0.6 | 4.3 |
| Example 1-46 | 1-46-2 | (X)/(Y) | 0.6 | 4.1 |
| Example 1-47 | 1-47-2 | (X)/(Y) | 0.9 | 2.3 |
| Example 1-48 | 1-48-2 | (X)/(Y) | 0.4 | 1.0 |
| Example 1-49 | 1-49-2 | (X)/(Y) | 0.4 | 1.0 |
| Comp. Example 1-1 | C1-1-2 | (X)/(CY) | 0.2 | 12.2 |
| Comp. Example 1-8 | C1-8-2 | (X)/(CY) | 0.2 | 14.8 |

As is apparent from Table 4, the multilayer structures of Examples successfully maintained the gas barrier properties at a high level after retorting.

### [Production examples of shaped products]

The following will describe examples where various shaped products were produced.

### <Example 1-50>

A vertical form-fill-seal bag was fabricated using a multilayer structure of the present invention. First, a multilayer structure (1-1) was fabricated in the same manner as in Example 1-1. Next, a two-component reactive polyurethane adhesive composed of "TAKELAC A-520" (trade name) manufactured by Mitsui Chemicals, Inc. and "TAKENATE A-50" (trade name) manufactured by Mitsui Chemicals, Inc. was applied and dried on the multilayer structure (1-1). The thus prepared product and an ONY were laminated together to obtain a layered product. Subsequently, a two-component reactive adhesive ("A-520" and "A-50" used above) was applied and dried on the oriented nylon film of the layered product. The thus prepared product and a CPP 70 were laminated together. In this way, a multilayer structure (1-50-2) having a configuration of "PET/layer (Y)/adhesive layer/ONY/adhesive layer/CPP" was obtained. Next, the multilayer structure (1-50-2) was cut into a 400-mm-wide piece, which was fed to a vertical form-fill-seal packaging machine (manufactured by ORIHIRO Co., Ltd.) to fabricate a vertical form-fill-seal bag of the fin seal type (having a width of 160 mm and a length of 470 mm). Next, the vertical form-fill-seal bag consisting of the multilayer structure (1-50-2) was filled with 2 kg of water using the form-fill-seal packaging machine. The processability of the multilayer structure (1-50-2) in the form-fill-seal packaging machine was good, and no defects such as wrinkles or streaks were observed in the appearance of the vertical form-fill-seal bag obtained.

### <Example 1-51>

A vacuum packaging bag was fabricated using a multilayer structure of the present invention. First, a multilayer structure (1-1) was fabricated in the same manner as in Example 1-1. Next, a two-component adhesive (A-520 and A-50 described in Example 1-40) was applied and dried on an ONY, and the thus prepared product and the multilayer structure (1-1) were laminated together. Next, a two-component reactive adhesive ("A-520" and "A-50" used in Example 1-50) was applied and dried on the laminated multilayer structure (1-1), and the thus prepared product and a CPP 70 were laminated together. In this way, a multilayer structure (1-51-2) having a configuration of "ONY/adhesive layer/layer (Y)/PET/adhesive layer/CPP" was obtained. Next, two pieces of layered product in the shape of a 22 cm × 30 cm rectangle were cut out from the multilayer structure (1-51-2). The two pieces of the multilayer structure (1-51-2) were stacked together in such a manner that the CPP 70s were located interiorly, and the rectangular stack was heat-sealed at its three sides to form a bag. Wood spheres (having a diameter of 30 mm) were selected as a model of a solid food, and the bag was packed with the spheres, which were closely arranged in a single layer to be in contact with each other. After that, the air inside the bag was removed by degassing, and the remaining one side was heat-sealed to fabricate a vacuum-packaged product. In the vacuum-packaged product obtained, the multilayer structure (1-51-2) was in close contact with the spheres along the irregularities of the spheres.

### <Example 1-52>

A spouted pouch was fabricated using a multilayer structure of the present invention. First, the multilayer structure (1-50-2) as described in Example 1-50 was cut into two pieces of a given shape, and the two pieces of the multilayer structure (1-50-2) were stacked together in such a manner that the CPP 70s were located interiorly. The edges of the stack were heat-sealed, and a spout made of polypropylene was then attached by heat sealing. In this way, a spouted pouch of the flat pouch type was successfully fabricated without any problem.

### <Example 1-53>

A laminated tube container was fabricated using a multilayer structure of the present invention. First, a multilayer structure (1-1) was fabricated in the same manner as in Example 1-1. Next, a two-component reactive adhesive ("A-520" and "A-50" used in Example 1-50) was applied and dried on two CPP 100s, and the thus prepared products and the multilayer structure (1-1) were laminated together. In this way, a multilayer structure (1-53-2) having a configuration of "CPP/adhesive layer/layer (Y)/PET/adhesive layer/CPP" was obtained. Next, the multilayer structure (1-53-2) was cut into a piece of a given shape, which was then formed into a tubular roll having an overlapping portion, which was heat-sealed to fabricate a tubular product. The tubular product was then mounted to a mandrel for tube container formation, and a shoulder portion in the shape of a frustum of a cone and a head portion continuous with the shoulder portion were formed at one end of the tubular product. The shoulder portion and the head portion were formed by compression molding of a polypropylene resin. Next, a cap made of polypropylene resin was attached to the head portion. The other open end of the tubular product was then heat-sealed. In this way, a laminated tube container was successfully fabricated without any problem.

### <Example 1-54>

An infusion bag was fabricated using a multilayer structure of the present invention. First, the multilayer structure (1-50-2) as described in Example 1-50 was cut into two pieces of a given shape, and the two pieces of the multilayer structure (1-50-2) were stacked together in such a manner that the CPP 70s were located interiorly. The edges of the stack were heat-sealed, and a spout made of polypropylene was then attached by heat sealing. In this way, an infusion bag was successfully fabricated without any problem.

### <Example 1-55>

A container lid was fabricated using a multilayer structure of the present invention. First, the multilayer structure (1-50-2) as described in Example 1-50 was cut to give a container lid in the shape of a circle of 88 mm diameter. There was also prepared a cylindrical container (Hi-Retoflex HR78-84, manufactured by Toyo Seikan Co., Ltd.) having a three-layer configuration of "polyolefin layer/steel layer/polyolefin layer" and having a diameter of 78 mm, a flange width of 6.5 mm, and a height of 30 mm. This container was almost fully filled with water, and the container lid consisting of the multilayer structure (1-50-2) was heat-sealed to the flange portion of the container. In this way, a lidded container including the container lid was successfully fabricated without any problem.

### <Example 1-56>

A paper container was fabricated using a multilayer structure of the present invention. First, a multilayer structure (1-1) was fabricated in the same manner as in Example 1-1. Next, an adhesive was applied onto both surfaces of a 400 g/m² paperboard, and then a polypropylene resin (which may be abbreviated as "PP" hereinafter) was applied to the two surfaces of the paperboard by extrusion coating lamination to form PP layers (each having a thickness of 20 µm) on the two surfaces. After that, an adhesive was applied to the surface of one of the PP layers, onto which the multilayer structure (1-1) was laminated. Furthermore, an adhesive was applied to the surface of the multilayer structure (1-1), to which a CPP 70 was then attached. In this way, a multilayer structure (1-56-2) having a configuration of "PP/paperboard/PP/adhesive layer/layer (Y)/PET/adhesive layer/CPP" was fabricated. In the fabrication of the multilayer structure (1-56-2), an anchor coat agent was used where necessary. With the use of the thus obtained multilayer structure (1-56-2), a brick-type paper container was successfully fabricated without any problem.

### <Example 1-57>

A vacuum insulator was fabricated using a multilayer structure of the present invention. First, the multilayer structure (1-51-2) as described in Example 1-51 was cut into two pieces of a given shape, and the two pieces of the multilayer structure (1-51-2) were stacked together in such a manner that the CPP 70s were located interiorly, and the rectangular stack was heat-sealed at its three sides to form a bag. Next, a heat-insulating core material was put into the bag through the opening portion of the bag, and the bag was hermetically closed using a vacuum packaging machine (VAC-STAR 2500, manufactured by Frimark GmbH) so that the internal pressure was 10 Pa at a temperature of 20°C. In this way, a vacuum insulator was successfully fabricated without any problem. The heat-insulating core material used was a fine silica powder dried in a 120°C atmosphere for 4 hours.

### [Example 2] Container

First, the surface of a PET bottle (with a volume of 500 mL, a surface area of 0.041 m², and a weight of 35 g) to be used as a base was subjected to plasma treatment. The first coating liquid (U-1) was applied to the surface of the PET bottle by dipping, followed by drying at 110°C for 5 minutes. The PET bottle was then heat-treated at 120°C for 5 minutes. In this way, a container (2-1) having a configuration of "base (X)/layer (Y)" was obtained.

A measurement sample with a size of 15 cm (circumferential direction) × 10 cm (longitudinal direction) was cut out from the barrel portion of the container (2-1), and was subjected to measurement of the oxygen transmission rate and moisture permeability before and after a stretching process. The result was that the oxygen transmission rate was 0.4 mL/(m² • day • atm) and the moisture permeability was 0.2 g/(m² • day) before the stretching process, while after the stretching process, the oxygen transmission rate was 1.1 mL/(m² • day • atm) and the moisture permeability was 1.6 g/(m² • day). The container of the present invention maintained the oxygen barrier properties and water vapor barrier properties at high levels even when exposed to a high physical stress. The stretching process was done by keeping the sample stretched by 5% in the circumferential direction for 10 seconds.

### [Example 3] Vertical form-fill-seal bag

A PET 12 was used as the base (X), and the first coating liquid (U-1) was applied onto the base using a bar coater in such a manner that the dry thickness would be 0.5 µm, and was then dried at 110°C for 5 minutes. This was followed by heat treatment at 180°C for 1 minute to fabricate a multilayer structure (3-1-1) having a configuration of "base (X)/layer (Y)". As a result of measurement of the infrared absorption spectrum of the multilayer structure (3-1-1), the maximum absorption wavenumber in the region of 800 to 1,400 cm⁻¹ was determined to be 1,107 cm⁻¹, and the half width of the maximum absorption band in the same region was determined to be 37 cm⁻¹.

An adhesive layer was formed on the multilayer structure (3-1-1) obtained, and an ONY was then laminated onto the adhesive layer to obtain a layered product. Next, an adhesive layer was formed on the ONY of the layered product, and a CPP 70 was then laminated onto the adhesive layer. The resulting layer product was allowed to stand still at 40°C for 5 days for aging. In this way, a multilayer structure (3-1-2) having a configuration of "base (X)/layer (Y)/adhesive layer/ONY/adhesive layer/CPP" was obtained. Each of the two adhesive layers was formed by applying a two-component reactive adhesive ("A-520" and "A-50" used in Example 1-50) using a bar coater in such a manner that the dry thickness would be 3 µm and then drying the adhesive. The multilayer structure (3-1-2) was cut into a 400-mm-wide piece, which was fed to a vertical form-fill-seal packaging machine (manufactured by ORIHIRO Co., Ltd.) in such a manner that the heat sealing was performed with the CPP layers being in contact with each other. Using the vertical form-fill-seal packaging machine, a vertical form-fill-seal bag (3-1) of the fin seal type (having a width of 160 mm and a length of 470 mm) as shown in FIG. 1 was fabricated. A measurement sample was cut out from the vertical form-fill-seal bag (3-1) and was subjected to measurement of the oxygen transmission rate and moisture permeability. The oxygen transmission rate was 0.4 mL/(m² • day• atm) and the moisture permeability was 0.2 g/(m² • day).

In a corrugated fiberboard box (15 × 35 × 45 cm) were placed 10 vertical form-fill-seal bags (3-1). A gap between the vertical form-fill-seal bags and the corrugated fiberboard box was filled with a buffer material. The corrugated fiberboard box containing the vertical form-fill-seal bags (3-1) was loaded onto a truck, and a transportation test was conducted in which the truck was allowed to run back and forth 10 times between Okayama and Tokyo (a distance of about 700 km). A measurement sample was cut out from the vertical form-fill-seal bag (2-1) having undergone the transportation test, and was subjected to measurement of the oxygen transmission rate and moisture permeability. The oxygen transmission rate was 0.9 mL/(m² • day • atm) and the moisture permeability was 0.8 g/(m² • day) after the transportation test. The vertical form-fill-seal bag of the present invention maintained the oxygen barrier properties and water vapor barrier properties at high levels even when exposed to a high physical stress.

### [Example 4] Vacuum packaging bag

Two layered products in the shape of a 22 cm × 30 cm rectangle were cut out from the multilayer structure (3-1-2) as fabricated in Example 3. The two pieces of the multilayer structure (3-1-2) were stacked together in such a manner that the CPP layers were located interiorly, and the rectangular stack was heat-sealed at its three sides to form a bag. Wood spheres (having a diameter of 30 mm) were selected as a model of a solid food, and the bag was packed with the spheres, which were closely arranged in a single layer to be in contact with each other. After that, the air inside the bag was removed by degassing, and the remaining one side was heat-sealed to obtain a vacuum packaging bag (4-1) containing the spheres vacuum-packed in such a manner that the bag was in close contact with the spheres along the irregularities of the spheres. A measurement sample was cut out from the vacuum packaging bag (4-1), and was subjected to measurement of the oxygen transmission rate and moisture permeability. The oxygen transmission rate was 0.6 mL/(m² • day • atm) and the moisture permeability was 0.3 g/(m² • day).

In a corrugated fiberboard box (15 × 35 × 45 cm) were placed 50 vacuum packaging bags (4-1). A gap between the vacuum packaging bags and the corrugated fiberboard box was filled with a buffer material. The corrugated fiberboard box containing the vacuum packaging bags (4-1) was loaded onto a truck, and a transportation test was conducted in which the truck was allowed to run back and forth 10 times between Okayama and Tokyo. A measurement sample was cut out from the vacuum packaging bag (4-1) having undergone the transportation test, and was subjected to measurement of the oxygen transmission rate and moisture permeability. The oxygen transmission rate was 0.9 mL/(m² • day • atm) and the moisture permeability was 0.8 g/(m² • day) after the transportation test. The vacuum packaging bag of the present invention maintained the oxygen barrier properties and water vapor barrier properties at high levels even when exposed to a high physical stress.

### [Example 5] Laminated tube container

Adhesive layers were respectively formed on two CPP 100s, which were then laminated to the multilayer structure (3-1-2) as obtained in Example 3. In this way, a laminated film having a configuration of "CPP/adhesive layer/multilayer structure/adhesive layer/CPP" was obtained. Each adhesive layer was formed by applying a two-component reactive adhesive ("A-520" and "A-50" used in Example 1-50) using a bar coater in such a manner that the dry thickness would be 3 µm and then drying the adhesive.

The laminated film obtained was cut into a piece of a given shape, which was then formed into a tubular roll having an overlapping portion, which was heat-sealed to produce a tubular barrel portion. This heat sealing was done between the inner CPP layer and the outer CPP layer. Next, the tubular barrel portion was mounted to a mandrel for tube container formation, and a shoulder portion having an outlet portion was joined to one end of the barrel portion. The shoulder portion was formed by compression molding of a polypropylene resin. A lid (cap) made of polypropylene resin was then attached to the outlet portion. Next, a green horseradish paste to be contained in the container was put through the other end of the barrel portion which was open, and this end was then heat-sealed in such a manner that the opposing portions of the inner circumferential surface formed by the inner CPP layer were in contact with each other. In this way, a laminated tube container (5-1) filled with a green horseradish paste was obtained. A measurement sample was cut out from the laminated tube container (5-1) and was subjected to measurement of the oxygen transmission rate and moisture permeability. The oxygen transmission rate was 0.6 mL/(m² • day • atm) and the moisture permeability was 0.3 g/(m²• day).

The laminated tube container (5-1) was subjected to a squeeze test in which its barrel portion was held between fingers and the fingers were moved back and forth along the barrel portion longitudinally with a certain force being applied to the barrel portion. After the fingers were moved back and forth 5,000 times, the contained green horseradish paste was let out. A measurement sample was cut out from the laminated tube container (5-1) having undergone the squeeze test and was subjected to measurement of the oxygen transmission rate and moisture permeability. The oxygen transmission rate was 0.9 mL/(m² • day • atm) and the moisture permeability was 0.8 g/(m² • day) after the squeeze test. The laminated tube container of the present invention maintained the oxygen barrier properties and water vapor barrier properties at high levels even when exposed to a high physical stress.

### [Example 6] Spouted pouch

Two laminates with a size of 20 cm × 13 cm were cut out from the multilayer structure (3-1-2) as obtained in Example 3. Subsequently, the two laminates cut out were stacked together in such a manner that the CPP layers were located interiorly, and then the entire outer periphery of the stack was heat-sealed with a seal width of 0.5 cm. Furthermore, a spout made of polypropylene was attached by heat sealing. In this way, a spouted pouch (6-1) of the flat pouch type was fabricated. A measurement sample was cut out from the pouch (6-1) and was subjected to measurement of the oxygen transmission rate and moisture permeability. The oxygen transmission rate was 0.4 mL/(m² • day • atm) and the moisture permeability was 0.2 g/(m² • day).

The pouch (6-1) was subjected to a bending test in which the pouch set in a position where a side (heat-sealed side) of the pouch faced downward was dropped from a height of 1.5 m five times. A measurement sample was cut out from the pouch (6-1) having undergone the bending test and was subjected to measurement of the oxygen transmission rate and moisture permeability. The oxygen transmission rate was 0.9 mL/(m² • day • atm) and the moisture permeability was 0.8 g/(m² • day). The spouted pouch of the present invention maintained the oxygen barrier properties and water vapor barrier properties at high levels even when exposed to a high physical stress.

### [Example 7] Flat pouch

Two laminates with a size of 20 cm × 13 cm were cut out from the multilayer structure (3-1-2) as fabricated in Example 3. Subsequently, the two laminates cut out were stacked together in such a manner that the CPP layers were located interiorly, and then three sides of the outer periphery of the stack were heat-sealed with a seal width of 0.5 cm. A pouch opening with a length of 30 mm was then formed at an edge of the one side remaining open. Next, a 30-mm-wide sheet of polytetrafluoroethylene was inserted into the edge of the open side and, in this state, heat sealing was performed. After heat sealing, the sheet of polytetrafluoroethylene was removed to obtain a flat pouch (7-1). A measurement sample was cut out from the flat pouch (7-1) and was subjected to measurement of the oxygen transmission rate and moisture permeability. The oxygen transmission rate was 0.4 mL/(m² • day • atm) and the moisture permeability was 0.2 g/(m² • day).

An amount of 400 mL of distilled water was charged into the flat pouch (7-1), so that the head space portion was narrowed as much as possible. The opening was then heat-sealed to close the pouch so as to prevent leakage of the distilled water charged. The flat pouch (7-1) hermetically enclosing distilled water was subjected to a bending test in which the pouch set in a position where a side (heat-sealed side) of the pouch faced downward was dropped from a height of 1.5 m five times. A measurement sample was cut out from the flat pouch (7-1) having undergone the bending test and was subjected to measurement of the oxygen transmission rate and moisture permeability. The oxygen transmission rate was 0.9 mL/(m² • day • atm) and the moisture permeability was 0.8 g/(m² • day). The flat pouch of the present invention maintained the oxygen barrier properties and water vapor barrier properties at high levels even when exposed to a high physical stress.

### [Example 8] Infusion bag

Two multilayer structures with a size of 12 cm × 10 cm were cut out from the multilayer structure (3-1-2) as fabricated in Example 3. Subsequently, the two multilayer structures cut out were stacked together in such a manner that the CPP layers were located interiorly. The edges of the stack were heat-sealed and a spout (plug member) made of polypropylene was attached by heat sealing. In this way, an infusion bag (8-1) having the same configuration as that shown in FIG. 5 was fabricated. A measurement sample was cut out from the infusion bag (8-1) and was subjected to measurement of the oxygen transmission rate and moisture permeability. The oxygen transmission rate was 0.4 mL/(m² • day • atm) and the moisture permeability was 0.2 g/(m² • day).

An amount of 100 mL of distilled water was charged into the infusion bag (8-1), which was then subjected to a bending test in which the bag set in a position where a side (heat-sealed side) faced downward was dropped from a height of 1.5 m five times. A measurement sample was cut out from the infusion bag (8-1) having undergone the bending test and was subjected to measurement of the oxygen transmission rate and moisture permeability. The oxygen transmission rate was 0.9 mL/(m²• day • atm) and the moisture permeability was 0.8 g/(m² • day). The infusion bag of the present invention maintained the oxygen barrier properties and water vapor barrier properties at high levels even when exposed to a high physical stress.

### [Example 9] Paper container

A polypropylene resin (PP) was applied to both surfaces of a 400 g/m² paperboard by extrusion coating lamination, and thus non-oriented PP layers (each having a thickness of 20 µm) were formed on both surfaces of the paperboard. An adhesive layer was then formed on the surface of one of the PP layers, onto which the multilayer structure (3-1-1) as obtained in Example 3 was laminated. The adhesive layer was formed using the adhesive described in Example 5. Next, the same adhesive was applied to the surface of the multilayer structure, and the multilayer structure and a CPP 50 were attached together. In this way, a multilayer structure (9-1-2) having a configuration of "PP (outer side)/paperboard/PP/multilayer structure/CPP (inner side)" was fabricated. The lamination of the multilayer structure (3-1-1) was done in such a manner that the layer (Y) was located closer to the paperboard than the base (X). Next, a brick-type paper container (9-1) (inner volume: 500 mL) was fabricated by shaping the multilayer structure (9-1-2) in such a manner that the CPP of the multilayer structure (9-1-2) faced the interior of the container.

A circular sample (diameter: 6.5 cm) was cut out to include a folded portion of the paper container (9-1). Next, the circular sample cut out was put in a 4.5-cm-diameter circular hole formed in a 10-cm-square aluminum foil (thickness: 30 µm), and the gap between the sample and the aluminum foil was filled with a two-component curable epoxy adhesive ("Araldite" (registered trademark) manufactured by NICHIBAN CO., LTD). The oxygen transmission rate and moisture permeability of the sample were measured. The oxygen transmission rate was 0.7 mL/(m² • day • atm) and the moisture permeability was 0.4 g/(m² • day). The paper container of the present invention maintained the oxygen barrier properties and water vapor barrier properties at high levels even when exposed to a high physical stress during shaping by folding.

### [Example 10] Strip tape

In Example 10, a brick-type paper container including a strip tape was fabricated and evaluated. First, the two-component adhesive as used in Example 5 was applied and dried on the multilayer structure (3-1-1), which was then laminated to a CPP 50 to obtain a laminate. Subsequently, the same two-component adhesive was applied and dried on the multilayer structure of the laminate, which was laminated to a CPP 50. In this way, a multilayer structure (10-1-2) having a configuration of "CPP/adhesive layer/multilayer structure/adhesive layer/CPP" was obtained. This multilayer structure (10-1-2) was cut into a strip shape to fabricate a strip tape.

Next, a paper container was fabricated in a manner similar to that in Example 9. In Example 10, the CPP and the polypropylene resin layer (PP) were heat-sealed at the center of one of the four side surfaces, and the heat-sealed portion formed at the center of the side surface was covered with the strip tape consisting of the multilayer structure (10-1-2). The portion covered with the strip tape was exposed to heat from the interior of the paper container to laminate the multilayer structure to the paper container. A paper container (10-1) was thus fabricated.

A circular sample (diameter: 6.5 cm) was cut out from the paper container (10-1) in such a manner that as large a part as possible of the sample was occupied by the laminated portion at the center of the side surface of the paper container. Next, the circular sample cut out was put in a 4.5-cm-diameter circular hole formed in a 10-cm-square aluminum foil (thickness: 30 µm), and the gap between the sample and the aluminum foil was filled with a two-component curable epoxy adhesive ("Araldite" (registered trademark) manufactured by NICHIBAN CO., LTD). The oxygen transmission rate and the moisture permeability of the sample were measured. The oxygen transmission rate was 0.6 mL/(m² • day • atm) and the moisture permeability was 0.2 g/(m² • day). The strip tape of the present invention maintained the oxygen barrier properties and water vapor barrier properties at high levels even after being exposed to a high physical stress caused by pressure or heat during heat sealing.

### [Example 11] Container lid

A 100-mm-diameter circular multilayer structure was cut out from the multilayer structure (3-1-2) as fabricated in Example 3 and used as a lid for a container. A flanged container ("Hi-Retoflex" (registered trademark), "HR 78-84" (trade name), manufactured by Toyo Seikan Co., Ltd.) was prepared as the container body. This container has the shape of a 30-mm-high cup whose top surface has a diameter of 78 mm. The top surface of the container is open, and the width of the flange portion formed along the periphery of the top surface is 6.5 mm. The container is composed of a three-layer structure having a configuration of "olefin layer/steel layer/olefin layer". The container body was then almost fully filled with water, and the lid was heat-sealed to the flange portion to obtain a lidded container (11-1). In this heat sealing of the lid, the lid was set in such a manner that the CPP layer of the lid was in contact with the flange portion. The oxygen transmission rate of the container, as determined by the measurement method used in the present examples, was substantially zero. A measurement sample was cut out from the lid of the lidded container (11-1) and was subjected to measurement of the oxygen transmission rate and moisture permeability. The oxygen transmission rate was 0.4 mL/(m² • day • atm) and the moisture permeability was 0.2 g/(m² day).

In a corrugated fiberboard box (15 × 35 × 45 cm) were placed 10 lidded containers (11-1). The gap between the lidded containers (11-1) and the corrugated fiberboard box was filled with a buffer material. The corrugated fiberboard box containing the lidded containers (11-1) was loaded onto a truck, and a transportation test was conducted in which the truck was allowed to run back and forth 10 times between Okayama and Tokyo. The lidded container (11-1) having undergone the transportation test was left at 20°C and 65%RH for 1 hour, after which a hole was made in the bottom of the container body to drain the water. Subsequently, a measurement sample was cut out from the lid of the lidded container (11-1) having undergone the transportation test and was subjected to measurement of the oxygen transmission rate and moisture permeability. The oxygen transmission rate was 0.9 mL/(m²• day• atm) and the moisture permeability was 0.8 g/(m²•day). The lidded container of the present invention maintained the oxygen barrier properties and water vapor barrier properties at high levels even when exposed to a high physical stress.

### [Example 12] In-mold labeled container

A two-component adhesive ("A-520" and "A-50" used in Example 1-50) was applied to two CPP 100s using a bar coater in such a manner that the dry thickness would be 3 µm, and the adhesive was dried. Next, the two CPPs were laminated to the multilayer structure (1-1) of Example 1-1, and the resulting laminate was allowed to stand still at 40°C for 5 days for aging. In this way, a multilayer label (12-1-2) having a configuration of "CPP/adhesive layer/base (X)/layer (Y)/adhesive layer/CPP" was obtained.

The multilayer label (12-1-2) was cut in conformity with the surface of the inner wall of a female mold member of a container-forming mold and attached to the surface of the inner wall of the female mold member. A male mold member was then pressed into the female mold member. Next, molten polypropylene ("EA7A" of "NOVATEC" (registered trademark) manufactured by Japan Polypropylene Corporation) was injected into a cavity between the male mold member and the female mold member at 220°C. The injection molding was carried out in this way to mold the intended container (12-1-3). The container body had a thickness of 700 µm and a surface area of 83 cm². The entire exterior of the container was covered with the multilayer label (12-1-2); that is, the multilayer label (12-1-2) overlapped the seam so that the exterior of the container was free of any area that was not covered with the multilayer label (12-1-2). The appearance of the container (12-1-3) was good.

A measurement sample was cut out from the body of the container in such a manner that the sample did not include the seam of the multilayer label, and the oxygen transmission rate and moisture permeability of the sample were measured. The result was that the oxygen transmission rate was 0.4 mL/(m² • day • atm) and the moisture permeability was 0.2 g/(m² • day). The in-mold labeled container of the present invention showed high levels of oxygen barrier properties and water vapor barrier properties even when exposed to a high physical stress caused by pressure or heat during in-mold labeling molding.

### [Example 13] Extrusion coating lamination

An adhesive layer was formed on the layer (Y) of the multilayer structure (1-1) of Example 1-1, and a polyethylene resin (density: 0.917 g/ cm³, melt flow rate: 8 g/10 min) was then applied onto the adhesive layer by extrusion coating lamination at 295°C in such a manner that the applied resin had a thickness of 20 µm. In this way, a multilayer structure (13-1-2) having a configuration of "base (X)/layer (Y)/adhesive layer/polyethylene" was obtained. The adhesive layer was formed by applying a two-component adhesive using a bar coater in such a manner that the dry thickness would be 0.3 µm and then drying the adhesive. This two-component adhesive used was a two-component reactive polyurethane adhesive composed of "A-3210" of "TAKELAC" (registered trademark) manufactured by Mitsui Chemicals, Inc. and "A-3070" of "TAKENATE" (registered trademark) manufactured by Mitsui Chemicals, Inc.

The oxygen transmission rate and moisture permeability of the multilayer structure (13-1-2) were measured by the methods described above. The result was that the oxygen transmission rate was 0.4 mL/(m²• day •atm) and the moisture permeability was 0.2 g/(m²• day). This demonstrates that by the use of the multilayer structure according to the present invention, high levels of oxygen barrier properties and water vapor barrier properties were achieved even after exposure to a high physical stress caused by pressure or heat during extrusion coating.

### [Example 14] Vacuum insulator

The two-component reactive polyurethane adhesive as used in Example 13 was applied onto a CPP 60 in such a manner that the dry thickness would be 3 µm, and the adhesive was dried to form an adhesive layer on the CPP 60. This CPP and the PET layer of the multilayer structure (3-1-2) as fabricated in Example 3 were attached together to obtain a layered product (14-1-1). Subsequently, the same two-component adhesive was applied onto an ONY in such a manner that the dry thickness would be 3 µm, and the adhesive was dried to form an adhesive layer on the ONY This ONY and the layered product (14-1-1) were attached together to obtain a multilayer structure (14-1-2) having a configuration of "CPP/adhesive layer/multilayer structure/adhesive layer/ONY".

The multilayer structure (14-1-2) was cut to obtain two laminates with a size of 70 cm × 30 cm. The two laminates were stacked together in such a manner that the CPP layers were placed as the inner layers, and the stack was heat-sealed at its three sides with a seal width of 10 mm. A three-side-seal bag was thus fabricated. Next, a heat-insulating core material was put into the three-side-seal bag through its opening, and the three-side-seal bag was hermetically closed using a vacuum packaging machine so that the internal pressure was 10 Pa at 20°C. In this way, a vacuum insulator (14-1) was obtained. The heat-insulating core material used was a fine silica powder. The vacuum insulator (14-1) was left at 40°C and 15%RH for 360 days, after which the pressure of the interior of the vacuum insulator was measured using a Pirani gauge. The measured pressure was 37.0 Pa.

A measurement sample was cut out from the vacuum insulator (14-1) and was subjected to measurement of the oxygen transmission rate and moisture permeability before and after a stretching process. The result was that the oxygen transmission rate was 0.4 mL/(m² •day •atm) and the moisture permeability was 0.2 g/(m²• day) before the stretching process, while after the stretching process, the oxygen transmission rate was 1.1 mL/(m² •day • atm) and the moisture permeability was 1.4 g/(m²• day). The stretching process was done by keeping the sample stretched by 5% in one direction corresponding to the longitudinal direction for 10 seconds. As understood from the above, the multilayer structure of the present invention maintained the oxygen barrier properties and water vapor barrier properties at high levels even when exposed to a high physical stress, and the vacuum insulator including the multilayer structure successfully maintained its internal pressure.

### [Example 15] Influence by packed material

### <Example 15-1>

Various liquid materials were packed into the flat pouches (7-1) as described in Example 7 in an amount of 500 mL each. The liquid materials used were a 1.5% aqueous ethanol solution (Example 15-1), vinegar (Example 15-2), an aqueous citric acid solution with a pH of 2 (Example 15-3), an edible oil (Example 15-4), ketchup (Example 15-5), soy sauce (Example 15-6), a ginger paste (Example 15-7), and a liquid containing 200 g of Japanese mandarin orange (Example 15-8). The flat pouches thus prepared were stored at 23°C and 50%RH for 6 months. A measurement sample was cut out from each of the flat pouches after the storage, and the oxygen transmission rate of the sample was measured. The oxygen transmission rate was 0.2 mL/(m² •day •atm) for all of the samples of Examples 15-1 to 15-8.

### <Example 15-2>

Various liquid materials were packed into the lidded containers (10-1) as described in Example 10, and the containers were sealed. The liquid materials used were a 1.5% aqueous ethanol solution (Example 15-9), vinegar (Example 15-10), an aqueous citric acid solution with a pH of 2 (Example 15-11), an edible oil (Example 15-12), ketchup (Example 15-13), soy sauce (Example 15-14), a ginger paste (Example 15-15), and a liquid containing 100 g of Japanese mandarin orange (Example 15-16). The lidded containers thus prepared were stored at 23°C and 50%RH for 6 months. A measurement sample was cut out from the lid of each of the lidded containers after the storage, and the oxygen transmission rate of the sample was measured. The oxygen transmission rate was 0.2 mL/(m²• day •atm) for all of the samples of Examples 15-9 to 15-16.

As is apparent from Examples 15-1 to 15-16, each packaging material including a multilayer structure of the present invention showed good barrier properties even after undergoing a storage test with a food being packed inside the packaging material.

### [Example 16] Protective sheet

### <Example 16-1>

A PET 12 was used as the base, and the first coating liquid (U-1) was applied onto the base (PET) using a bar coater in such a manner that the dry thickness would be 0.5 µm. The coating liquid was dried at 110°C for 5 minutes, followed by heat treatment at 180°C for 1 minute. In this way, a multilayer structure (16-1) having a configuration of "base (X)/layer (Y)" was obtained. An infrared absorption spectrum of the obtained structure was measured. As a result, the maximum absorption wavenumber in the region of 800 to 1,400 cm⁻¹ was determined to be 1,107 cm⁻¹, and the half width of the maximum absorption band was determined to be 37 cm⁻¹.

An adhesive layer was formed on a 50-µm-thick acrylic resin film, which was then laminated to the multilayer structure (16-1) to obtain a layered product. Subsequently, an adhesive layer was formed on the multilayer structure (16-1) of the layered product, and the layered product was then laminated to a PET 50. In this way, a protective sheet (16-1) having a configuration of "PET/adhesive layer/base (X)/layer (Y)/adhesive layer/acrylic resin film" was obtained. Each of the two adhesive layers was formed by applying a two-component adhesive in such a manner that the dry thickness would be 3 µm and then drying the adhesive. The two-component adhesive used was a two-component reactive polyurethane adhesive composed of "A-1102" of "TAKELAC" (registered trademark) manufactured by Mitsui Chemicals, Inc. and "A-3070" of "TAKENATE" (registered trademark) manufactured by Mitsui Chemicals, Inc.

The oxygen transmission rate and moisture permeability of the protective sheet (16-1) obtained were measured. The oxygen transmission rate was 0.4 mL/(m² •day • atm) and the moisture permeability was 0.2 g/(m² •day). In addition, a measurement sample with a size of 15 cm × 10 cm was cut out from the protective sheet (16-1). The sample was left at 23°C and 50%RH for 24 hours, after which, under the same conditions, the sample was subjected to a stretching process in which it was stretched by 5% and allowed to keep the stretched state for 10 seconds. The oxygen transmission rate and moisture permeability of the protective sheet (16-1) having undergone the stretching process were measured. The oxygen transmission rate was 1.1 mL/(m² • day • atm) and the moisture permeability was 1.6 g/(m² • day) after the stretching process.

### <Comparative Example 16-1>

A multilayer structure (C16-1) was fabricated in the same manner as in the fabrication of the multilayer structure (16-1) of Example 16-1, except for using the first coating liquid (CU-1) instead of the first coating liquid (U-1).

A protective sheet (C16-1) was fabricated in the same manner as in the fabrication of the protective sheet (16-1) of Example 16-1, except for using the multilayer structure (C16-1) instead of the multilayer structure (16-1). The protective sheet (C16-1) was evaluated in the same manner as in Example 16-1. The oxygen transmission rate was 0.2 mL/(m²• day• atm) and the moisture permeability was 6.1 g/(m²• day) before the stretching process, while after the stretching process, the oxygen transmission rate was 0.4 mL/(m² • day • atm) and the moisture permeability was and 7.2 g/(m²• day).

The protective sheet (multilayer structure) of Example showed higher resistance to stretching-induced damage than the protective sheet of Comparative Example.

### <Example 16-2>

The protective sheet (16-1) obtained in Example 16-1 was tested for flexibility. Specifically, a test was conducted in which the protective sheet (16-1) was wound 20 times around the outer circumferential surface of a stainless steel cylindrical tube (outer diameter: 30 cm). Any damage caused by this test to the protective sheet (16-1) was not observed. This verified that the protective sheet (16-1) had flexibility.

### <Example 16-3>

A solar cell module was fabricated using the multilayer structure (16-1) obtained in Example 16-1 as a protective sheet. An amorphous silicon solar cell placed on 10-cm-square tempered glass was sandwiched between two ethylene-vinyl acetate copolymer sheets with a thickness of 450 µm. The multilayer structure (16-1) was then laminated to one of the ethylene-vinyl acetate copolymer sheets that was to receive incident light in such a manner that the PET layer of the multilayer structure (16-1) faced outwardly. In this way, the solar cell module was fabricated. The lamination was done by vacuum drawing at 150°C for 3 minutes, followed by compression bonding for 9 minutes. The fabricated solar cell module operated well and continued to show good electrical output characteristics over a long period of time.

### INDUSTRIAL APPLICABILITY

The multilayer structure of the present invention is superior in gas barrier properties and water vapor barrier properties. In addition, the multilayer structure of the present invention is capable of maintaining the gas barrier properties and water vapor barrier properties at high levels even when exposed to physical stresses such as deformation and impact. The multilayer structure of the present invention can therefore be preferably used as a packaging material, for example, for foods, chemicals, medical devices, industrial materials, and garments.

Examples of applications other than the use as a packaging material include uses as or in: electronic device-related films such as a substrate film for LCDs, a substrate film for organic EL devices, a substrate film for electronic paper, a sealing film for electronic devices, a film for PDPs, a film for LEDs, a film for IC tags, a back sheet for solar cells, and a protective film for solar cells; a member for optical communication; a flexible film for electronic equipment; a barrier membrane for fuel cells; a sealing film for fuel cells; and a substrate film for various functional films.

## Claims

1. A multilayer structure comprising a base (X) and a layer (Y) stacked on the base (X), wherein
the layer (Y) comprises a metal oxide (A), a phosphorus compound (B), and cations (Z) with an ionic charge (Fz) of 1 or more and 3 or less,
the phosphorus compound (B) comprises a compound containing a moiety capable of reacting with the metal oxide (A),
the number of moles (N_{M}) of metal atoms (M) constituting the metal oxide (A) and the number of moles (N_{P}) of phosphorus atoms derived from the phosphorus compound (B) satisfy a relationship of 0.8 ≤ N_{M}/N_{P} ≤ 4.5 in the layer (Y), and
the number of moles (N_{M}), the number of moles (Nz) of the cations (Z), and the ionic charge (Fz) satisfy a relationship of 0.001 ≤ Fz × N_{Z}/N_{M} ≤ 0.60 in the layer (Y).

2. The multilayer structure according to claim 1, wherein the cations (Z) comprise at least one selected from the group consisting of lithium ions, sodium ions, potassium ions, magnesium ions, calcium ions, titanium ions, zirconium ions, lanthanoid ions, vanadium ions, manganese ions, iron ions, cobalt ions, nickel ions, copper ions, zinc ions, boron ions, aluminum ions, and ammonium ions.

3. The multilayer structure according to claim 1 or 2, wherein the number of moles (N_{M}), the number of moles (Nz), and the ionic charge (Fz) satisfy a relationship of 0.01 ≤ Fz × N_{Z}/N_{M} ≤ 0.60 in the layer (Y).

4. The multilayer structure according to any one of claims 1 to 3, wherein the phosphorus compound (B) comprises at least one compound selected from the group consisting of phosphoric acid, polyphosphoric acid, phosphorous acid, phosphonic acid, phosphonous acid, phosphinic acid, phosphinous acid, and derivatives thereof.

5. The multilayer structure according to any one of claims 1 to 4, wherein, in an infrared absorption spectrum of the layer (Y), a maximum absorption wavenumber in a region of 800 to 1,400 cm⁻¹ is 1,080 to 1,130 cm⁻¹.

6. The multilayer structure according to any one of claims 1 to 5, wherein the base (X) comprises at least one layer selected from the group consisting of a thermoplastic resin film layer, a paper layer, and an inorganic deposited layer.

7. A method for producing the multilayer structure according to claim 1, the method comprising:
a step [I] of mixing a metal oxide (A), a phosphorus compound (B) containing a moiety capable of reacting with the metal oxide (A), and an ionic compound (E) containing cations (Z) with an ionic charge (Fz) of 1 or more and 3 or less, so as to prepare a first coating liquid (U);
a step [II] of applying the first coating liquid (U) onto the base (X) to form a precursor layer of the layer (Y) on the base (X); and
a step [III] of heat-treating the precursor layer at a temperature of 110°C or higher, wherein
the number of moles (N_{M}) of metal atoms (M) constituting the metal oxide (A) and the number of moles (N_{P}) of phosphorus atoms derived from the phosphorus compound (B) satisfy a relationship of 0.8 ≤ N_{M}/N_{P} ≤ 4.5 in the first coating liquid (U), and
the number of moles (N_{M}), the number of moles (Nz) of the cations (Z), and the ionic charge (Fz) satisfy a relationship of 0.001 ≤ F_{Z} × N_{Z}/N_{M} ≤ 0.60 in the first coating liquid (U).

8. The production method according to claim 7, further comprising:
a step [i] of preparing a second coating liquid (V) containing a polymer (G1) and a solvent; and
a step [ii] of applying the second coating liquid (V) onto the layer (Y).

9. A coating liquid for use in the production method according to claim 7, wherein
the cations (Z) comprise at least one selected from the group consisting of lithium ions, sodium ions, potassium ions, magnesium ions, calcium ions, titanium ions, zirconium ions, lanthanoid ions, vanadium ions, manganese ions, iron ions, cobalt ions, nickel ions, copper ions, zinc ions, boron ions, aluminum ions, and ammonium ions,
the number of moles (N_{M}) of metal atoms (M) constituting the metal oxide (A) and the number of moles (N_{P}) of phosphorus atoms derived from the phosphorus compound (B) satisfy a relationship of 0.80 ≤ N_{M}/N_{P} ≤ 4.50, and
the number of moles (N_{M}), the number of moles (Nz) of the cations (Z), and the ionic charge (Fz) satisfy a relationship of 0.001 ≤ Fz × N_{Z}/N_{M} ≤ 0.60.

10. A packaging material comprising the multilayer structure according to any one of claims 1 to 6.

11. The packaging material according to claim 10, further comprising a layer formed by extrusion coating lamination.

12. The packaging material according to claim 10 or 11, being a vertical form-fill-seal bag, a vacuum packaging bag, a pouch, a laminated tube container, an infusion bag, a paper container, a strip tape, a container lid, or an in-mold labeled container.

13. A product comprising the packaging material according to claim 10 in at least a part of the product.

14. The product according to claim 13, adapted to function as a vacuum insulator,
the product having an interior with a reduced pressure,
the product comprising a substance contained in the interior, the substance being a core material.

15. A protective sheet for electronic devices, comprising the multilayer structure according to any one of claims 1 to 6.

16. The protective sheet for electronic devices according to claim 15, the protective sheet being adapted to protect a surface of a photoelectric conversion device, an information display device, or a lighting device.

17. An electronic device comprising the protective sheet according to claim 15 or 16.
